**Europäisches Patentamt**

**(19) European Patent Office**

**Office européen des brevets**

(11) Publication number : **0 494 267 B1**

(12) # EUROPEAN PATENT SPECIFICATION

(45) Date of publication of patent specification :
**25.01.95 Bulletin 95/04**

(51) Int. Cl.⁶ : **G11B 7/00,** G11B 20/12,
H03M 7/00, H03M 13/00,
G06K 7/10, G03B 31/02

(21) Application number : **90916000.4**

(22) Date of filing : **17.09.90**

(86) International application number :
**PCT/US90/05211**

(87) International publication number :
**WO 91/05335 18.04.91 Gazette 91/09**

(54) **DIGITAL OPTICAL SOUND SYSTEM.**

(30) Priority : **29.09.89 US 415020**

(43) Date of publication of application :
**15.07.92 Bulletin 92/29**

(45) Publication of the grant of the patent :
**25.01.95 Bulletin 95/04**

(84) Designated Contracting States :
**DE FR GB**

(56) References cited :
**EP-A- 0 177 950**
**EP-A- 0 231 380**
**US-A- 4 517 552**
**US-A- 4 600 280**

(73) Proprietor : **EASTMAN KODAK COMPANY**
**343 State Street**
**Rochester, New York 14650-2201 (US)**

(72) Inventor : **BERLEKAMP, Elwyn, R.**
**120 Hazel Lane**
**Piedmont, CA 94611 (US)**
Inventor : **WELCH, Lloyd, R.**
**4822 Indianola Way**
**La Canada, CA 91011 (US)**

(74) Representative : **Schmidt, Peter, Dipl.-Ing.**
**KODAK Aktiengesellschaft**
**Patentabteilung**
**D-70323 Stuttgart (DE)**

## Description

BACKGROUND OF THE INVENTION

The concept of providing digital sound with cinema film by photographically recording digital audio bits as optical pixels in a stripe along one edge of the film is well-known in the art, as disclosed in U.S. Patent No. 4,600,280 to Clark. However, such an approach is fraught with perils, including the tendency of the cinema projector to run the film at an unsteady speed and to allow the film to wander laterally across the projector gate. The result is that significant portions of the digital audio bytes photographically recorded on the film are lost or corrupted during playback. This creates unacceptable and distracting noise during the showing of a movie, making the entire concept impractical for commercial use.

This problem was recognized in U.S. Patent No. 4,839,733 to Karamon et al., in which a solution to the problem is proposed. Karamon et al. propose matching the digital sound track to a conventionally recorded sound track on another portion of the film. If a portion the digital sound track is clearly different from the presumably more reliable conventional sound track, then that portion is discarded and the conventional sound track is used to fill the resulting void. One disadvantage of this approach is that a problem with the digital sound track is not identified until it causes the digital sound track to be at least as bad if not worse in quality than the conventional sound track. Another disadvantage is that, once a problem is identified, the only solution is to temporarily switch to the lower quality conventional sound track, causing a noticeable loss of quality. In many uses, this would be unacceptable. Accordingly, the concept of digital optical sound continues to be mired by problems which at least threaten to make the concept impractical or unmarketable.

Accordingly, there is a great need for a digital optical sound system which automatically corrects for loss of digital audio data caused by movie projector speed fluctuations or by lateral film wander in the projector or by dirt or dust obsuring individual digital pixels on the film.

SUMMARY OF THE INVENTION

According to the present invention there is provided a system as defined in independent claim 1 and a method as defined in independent claim 21.

Estimates of the horizontal and vertical positions of optical bits on the film are corrected by tracking the bit transition boundaries in the horizontal and vertical directions. Frequency of useful film bit transitions in the vertical direction is maximized prior to recording by error correction encoding the digital audio bytes using a symmetrical generator polynomial and then selectively inverting symmetric portions of each codeword. Useful transitions are those in which the bits in alternate rows of the same column are different. Thus, the codeword inversion is performed by monitoring the number of such transitions for each possible inversion of the codeword, and then selecting that inversion having the greatest number of such transitions.

During playback, a row clock generator estimates the position of the transitions between horizontal rows of film bits by deciding whether the row clock leads or lags the actual timing of the horizontal film rows past the image sensor. It subtracts the average row luminance from the luminance of each pixel. The resulting differences are compared bit-by-bit with the corresponding differences obtained for the previous row. There are eight possible combinations for each such comparison, as each of the two compared values can be either positive or negative and can have a magnitude either greater or less than that of the other. Each combination is an unambiguous indication of either a lead or a lag condition of the row clock signal with respect to the actual occurrence of row transitions at the image sensor. The results of the comparison address a programmable-read-only-memory (PROM) which maps the eight possible combinations to appropriate lead or lag conditions. The algebraic sum of all the lead and lag conditions across the entire row is computed. The modulus of a row clock counter is either decremented or incremented, depending upon whether the algebraic sum is positive or negative.

Frequency of useful film bit transitions in the horizontal direction is maximized prior to recording by channel encoding the error correction symbols in each codeword so as to force the weight of the resulting symbol to be half the number of data bits per symbol. In other words, the occurrence of alternating zeroes and ones across a row of film bits is maximized. During playback, errors in the horizontal film bit position estimates are corrected by computing partial sums of sines and cosines of successive film bit positions across a horizontal row. This computation takes advantage of the period location of pixels across the linear image sensor viewing each film bit row. Based upon the determination thus made of the center of each film bit, a particular one or a weighted pair of the image sensor pixels is chosen as representative of the current film bit.

The magnitude of each film bit thus located is measured and compared to predetermined magnitudes representative of binary zero and one values. If the measured magnitude is not sufficiently close to either, then an erasure flag is transmitted along with the closest binary data value. The boundaries between received codeword symbols are determined in an electoral process in which the symbol weights of all possible boundaries are determined, with the boundary resulting in the symbol weight of the channel code being declared the winner. If this results in an indication that the current periodic set of symbol boundaries must be changed, the following steps are first taken before such a change is made. False indications of symbol boundary errors are eliminated by first attempting to achieve the requisite symbol weight by inverting those bits accompanied by an erasure flag. If such inversion succeeds, the symbols containing the inverted bits are flagged as erasures. Otherwise, a non-decode flag is transmitted along with the present codeword.

The error correction code performance is optimized by first attempting to decode each codeword while using the erasure flags as error locator symbols. If the decoder finds no error value symbols for certain ones of the erased symbol locations, then the symbols in those locations are used as valid symbols in a second decoding attempt by the decoder. In the second attempt, the useful number of erasure and errors is limited to a predetermined number significantly less than the maximum capacity of the decoder. If the number of erasures and corrections exceeds the predetermined number when the decoder begins its second pass, then a mis-decode flag is transmitted. Presumably, however, the inversion of the erased bits results in fortuitously correct guess and therefore usually decreases the total number of erasures and errors below the predetermined number. This greatly enhances the reliability of the error correction decoder. By maintaining the admissible number of errors and erasures below the maximum number allowed by the code, the probability of a mis-decode (i.e., a decoded codeword which is apparently but not really correct) is minimized to an insignificant level.

## DESCRIPTION OF THE DRAWINGS

The invention is best understood by reference to the accompanying drawings, of which:

Fig. 1 is a pictorial diagram of digital optical film bits photographically recorded on a strip of film;

Fig. 2 is a pictorial diagram illustrating image sensor pixels overlying the film bits of Fig. 1;

Fig. 3 is a schematic block diagram of an encoding system embodying one aspect of the invention;

Fig. 4 is a flow diagram illustrating the operation of a Reed-Solomon encoder of the encoding system of Fig. 3;

Fig. 5 is a table illustrating the contents of a six-to-eight encoder PROM of the encoding system of Fig. 3;

Fig. 6 is a diagram illustrating the format of encoded data generated by the encoder system of Fig. 3;

Fig. 7 is a diagram illustrating one example of film byte transition detected at one image sensor pixel scanning successive film bits as a function of time;

Fig. 8 illustrates useful data transitions in the encoded data generated by the encoder system of Fig. 3;

Fig. 9 is a graph illustrating the probability of occurrence of useful film bit transitions in the encoded data of Fig. 8;

Fig. 10 illustrates the juxtaposition of alternate rows for determining the number of useful film bit transitions in the encoded data;

Fig. 11 is a schematic block diagram illustrating the operation of a sub-codeword inverter in the encoder system of Fig. 3;

Fig. 12 is a schematic block diagram of a decoding system embodying another aspect of the invention;

Fig. 13 illustrates the relationship of the various types of useful film bit transitions to a lead and lag condition of a row clock signal of the image sensor with respect to the timing of successive film bit rows;

Fig. 14 is a schematic block diagram of a row clock generator in the decoding system of Fig. 12;

Fig. 15a is a pictorial diagram corresponding to Fig. 2;

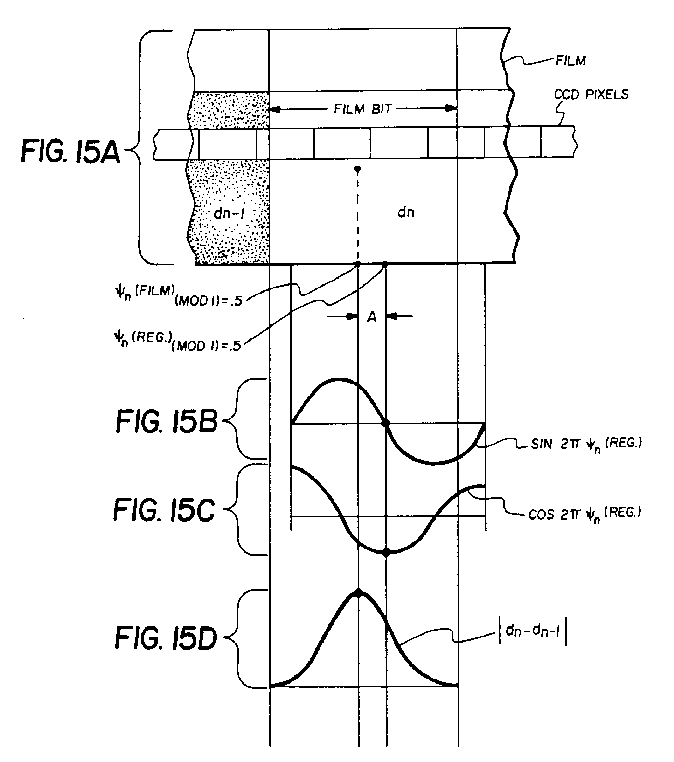

Fig.'s 15b and 15c are graphs corresponding to Fig. 15a and illustrating the periodic nature of sines and cosines, respectively of the horizontal location in a row of film bits with respect to the film bit boundaries;

Fig. 15d is a graph corresponding to Fig. 15a and illustrating the film bit transition magnitude sensed by individual pixels of the image sensor as a function of horizontal location along the sensor;

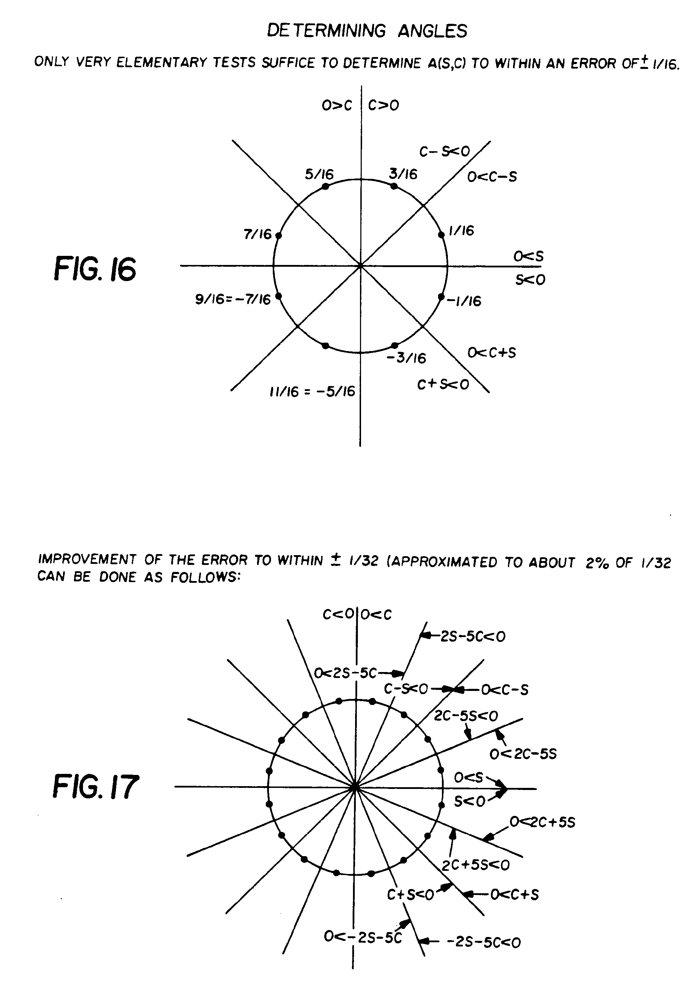

Fig. 16 illustrates a simple test based upon cumulative sums of the sines and cosines of Fig.'s 15b and 15c to determine the error in the current estimate of the periodic horizontal locations of the centers of successive film bits;

Fig. 17 illustrates a more robust version of the test illustrated in Fig. 16;

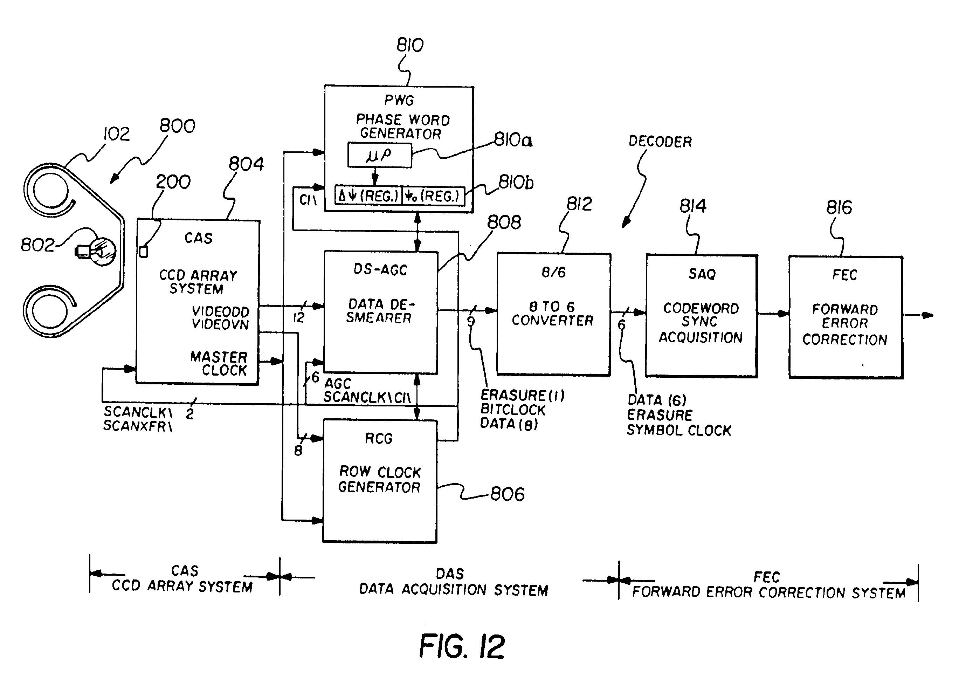

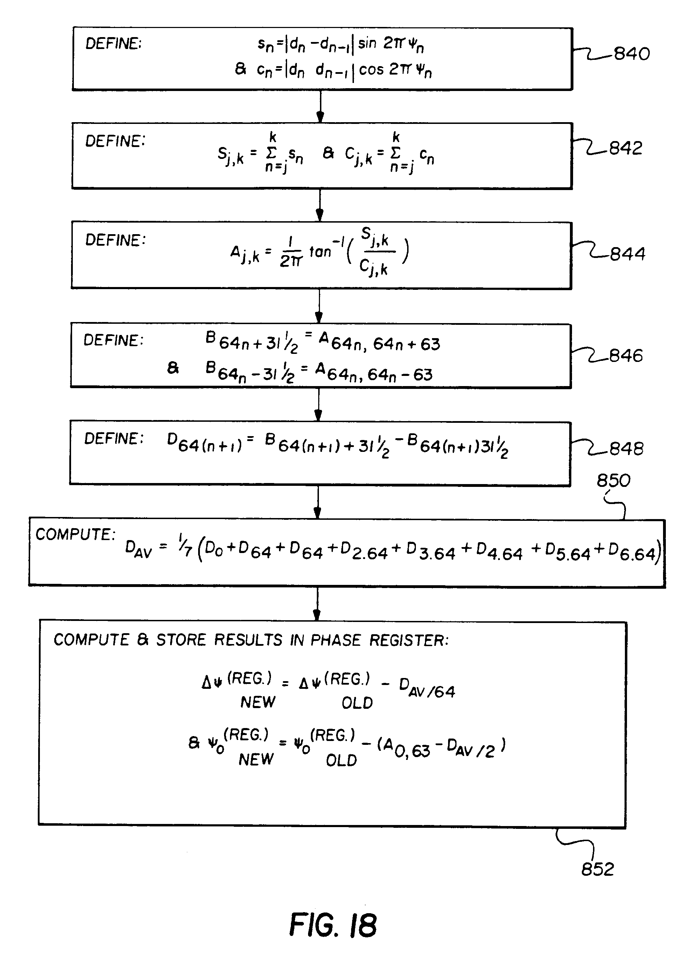

Fig. 18 is a flow diagram illustrating the operation of a microprocessor in a phase word generator of the decoder system of Fig. 12:

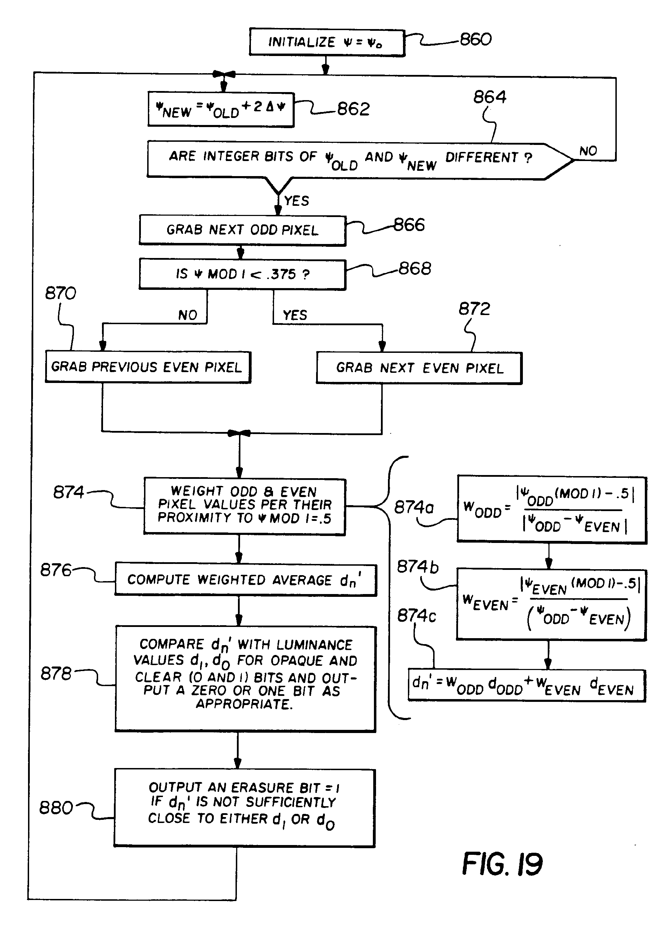

Fig. 19 is a flow diagram illustrating the operation of a data desmearer of the decoder system of Fig. 12;

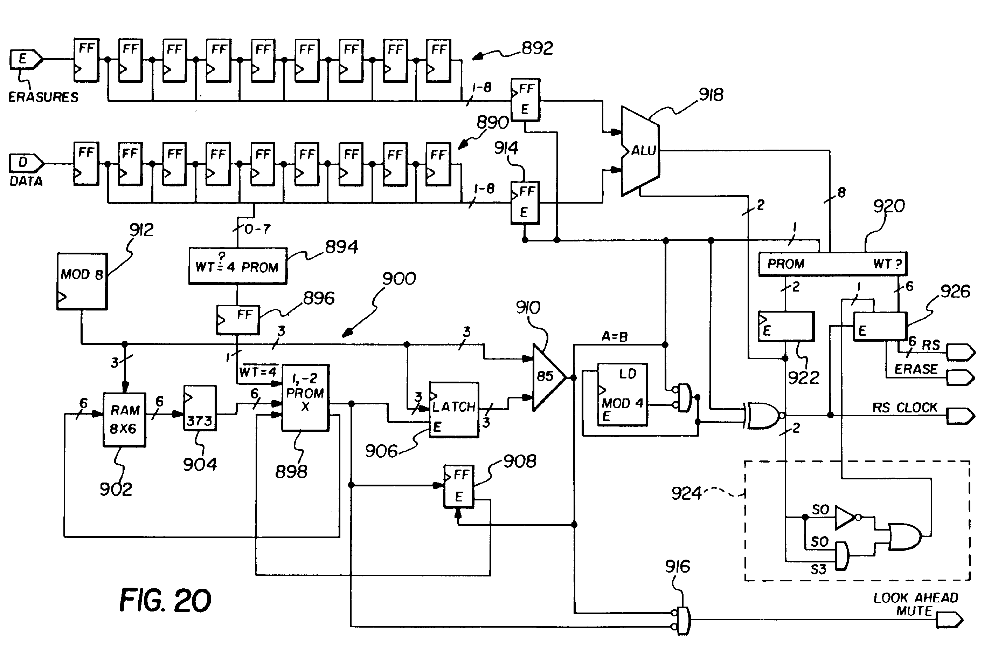

Fig. 20 is a block diagram of the data desmearer of the decoder system of Fig. 12;

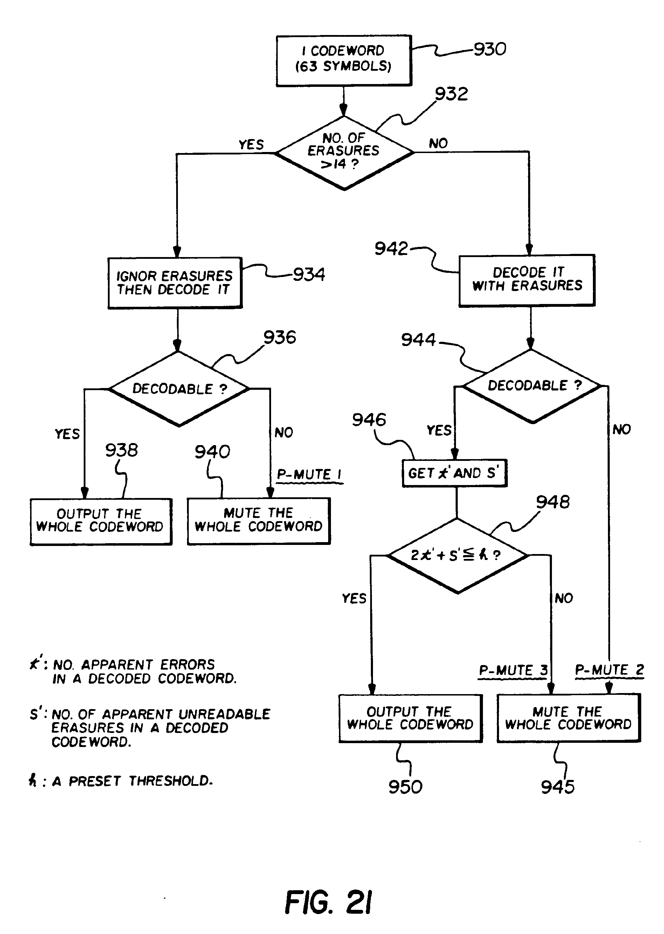

Fig. 21 is a flow diagram illustrating the operation of a forward error corrector of the decoder system of Fig. 12; and

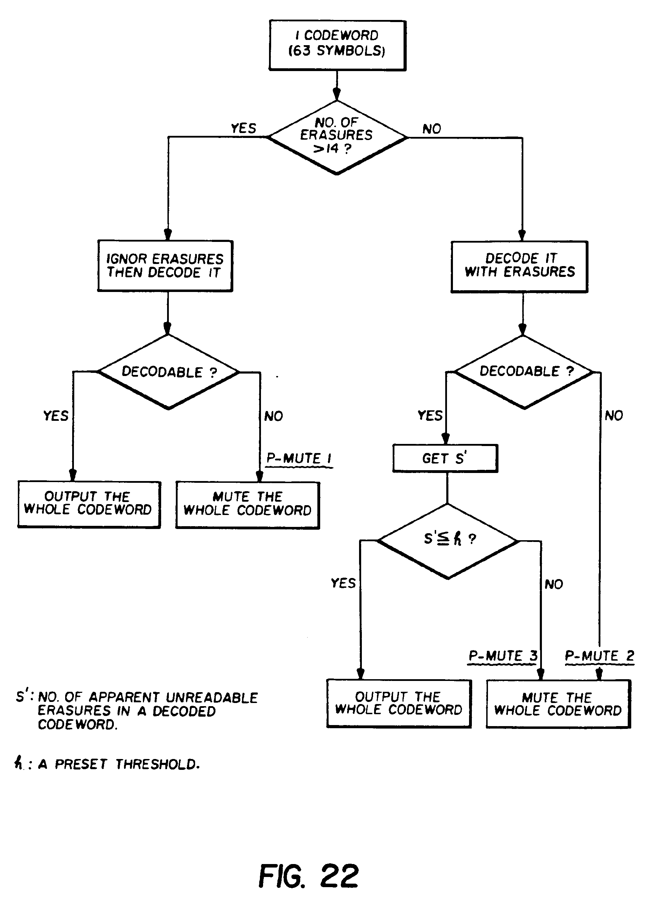

Fig. 22 is a flow diagram illustrating an alternative embodiment of the operation of the forward error corrector of the decoder system of Fig. 12.

DETAILED DESCRIPTION OF THE INVENTION

Problems to be Solved

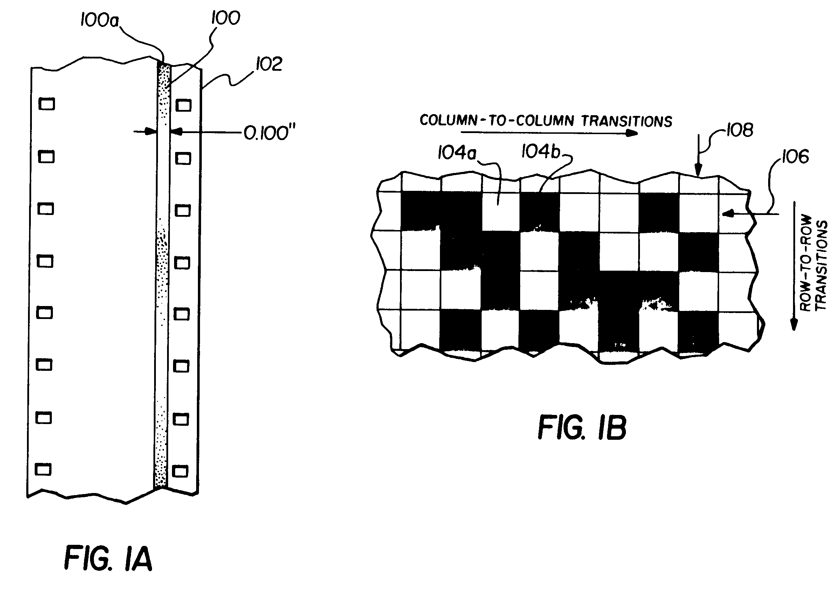

Referring to Fig. 1, digital bits are photographically recorded in a "sound stripe" 100 along one edge of a strip of film 102 as individual black squares 104 organized into parallel horizontal rows 106 and parallel vertical columns 108. A square --or "film bit"--104a which is clear represents a binary "one" while a film bit 104b which is opaque represents a binary "zero", for example. Even though the film bits 104 may have been photographically recorded onto the film 102 with virtually perfect accuracy, the film bits 104 must be accurately "read" by a linear image sensor as the film is longitudinally transported in a projector. Unfortunately, such a projector transports the film 102 in a manner characterized by significant fluctuations in film transport speed. Such fluctuations distort the appearance of the row-to-row transitions between adjacent film bits within a column 108, making it difficult for the image sensor to maintain synchronization with the successive horizontal rows 106 presented to it as the film is transported. Moreover, such a projector allows the film 102 to wander laterally within its film gate and therefore with respect to the image sensor. Such lateral wandering distort the appearance of the column-to-column transitions between adjacent film bits within a row 106, making it difficult for the image sensor to distinguish among adjacent film bits within a row.

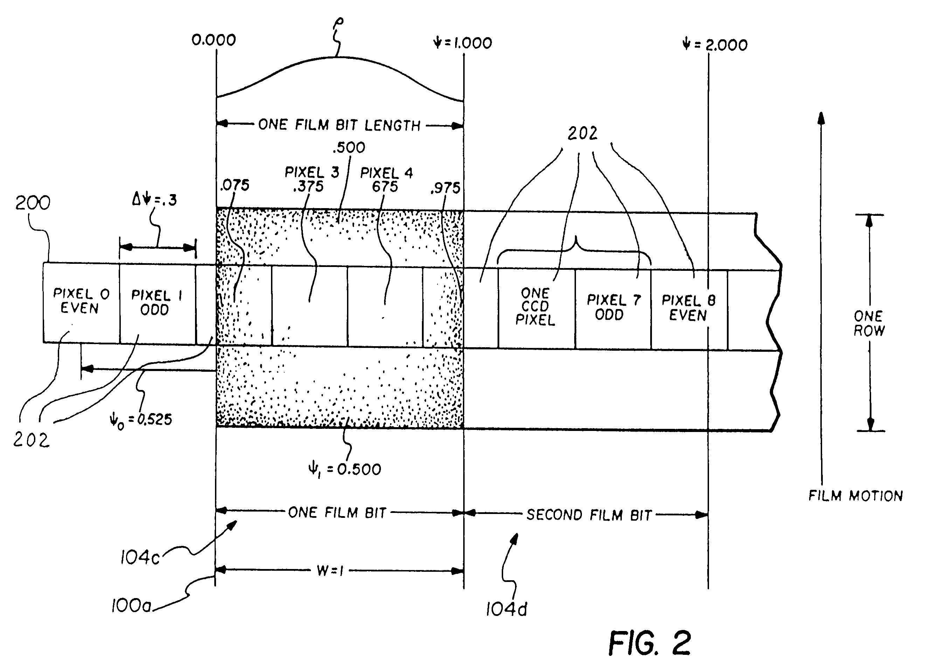

Referring to Fig. 2, an opaque film bit 104c lying along the inner edge 100a of the sound stripe 100 and an adjacent clear film bit 104d underlie a linear image sensor 200 extending across one complete horizontal row 106 of film bits 104. The linear image sensor 200 may be a charge coupled device (CCD) linear imaging array of individual pixels, for example, labelled pixel 1, pixel 2, pixel 3, etc., in Fig. 2. The density of the opaque film bit 106c falls off slightly near the edges of the film bit, as illustrated by the curve labelled "$\rho$". Therefore, the best representation of a film bit and of corresponding film bit transitions is given by the CCD pixel nearest the center of the film bit. Of course, as the film 102 laterally wanders with respect to the image sensor 200, the film bit center may wander under different CCD pixels.

One problem is how to always choose those CCD pixels nearest the centers of respective film bits in a given row despite lateral film wandering. Another problem is how to distinguish byte boundaries among succeeding film bits in a horizontal row. Yet another problem is how to maintain synchronization of the linear image sensor 200 with the passage of the horizontal film bit rows 106 across the sensor 200 despite fluctuations in film transport speed. This latter problem arises from the desirability of taking a "snapshot" of the CCD pixels precisely when the center of the current horizontal film bit row 106 is aligned with the linear CCD array 200.

Encoding System

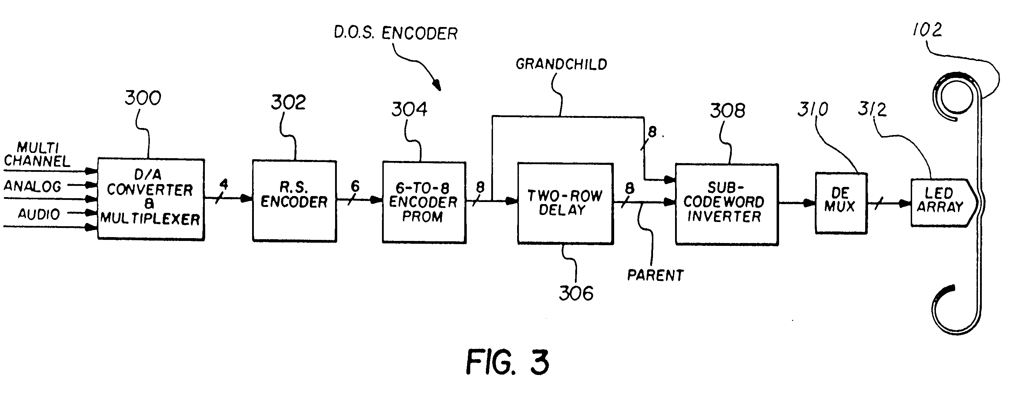

Fig. 3 illustrates an encoding system which records digital optical signals in accordance with the invention. An analog-to-digital converter 300 converts, for example, multi-channel analog audio sound signals to binary data streams comprising successive four-bit symbols, and multiplexes them into a single data stream of four-bit symbols. An encoder 302 encodes the data stream in accordance with a BCH error correction code, such as a Reed-Solomon code, and inserts certain control and sychronization bits in predetermined locations.

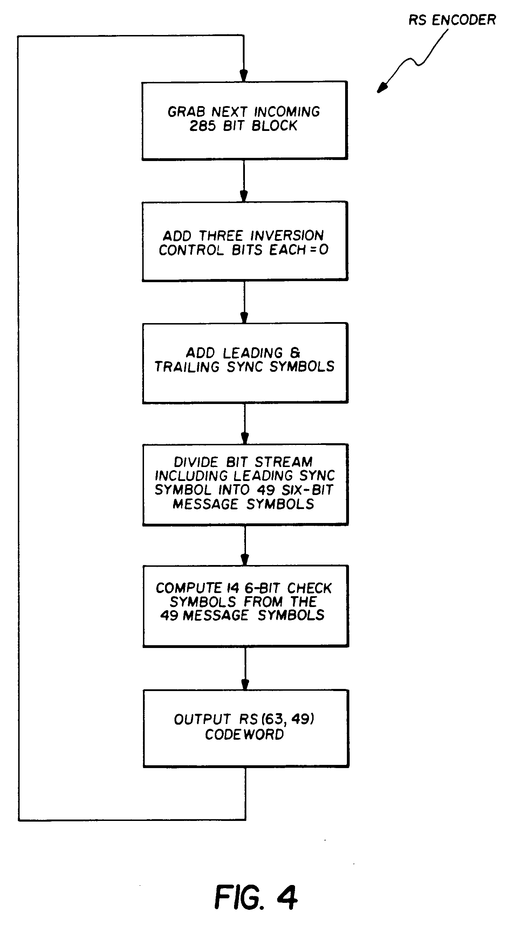

Referring to Fig. 4, the encoder 302 grabs the next incoming block of 285 bits from the converter 300 and inserts three control bits of zero value as the first, sixth and twelfth bit, respectively, in the data block. The encoder 302 then prefixes and appends six-bit leading and trailing sync symbols, respectively, to the (now) 288-bit block. The encoder 302 then divides the block into 49 six-bit symbols--including the leading sync symbol and not including the trailing sync symbol--and treats these 49 symbols as message symbols. The encoder 302 computes 14 redundant six-bit check symbols in accordance with a code generator polynomial and appends these 14 check symbols to the block to form a 63-symbol codeword. Preferably, for reasons which will be explained below, the code generator polynomial is a symmetrical or "palindromic" Reed-Solomon code generator polynomial. While in this example the code is an RS(63,49) code, it should be understood that other choices may be made for the number of bits in each audio byte generated by the converter 300, the number of bits in each block grabbed by the encoder 302 and the number of bits in each codeword symbol as well as the number of symbols in each codeword. Thus, palindromic codes other than RS(63,49) may be employed in the invention.

Encoding to Maximize the Number of Useful Film Bit Transitions in the Horizontal Direction

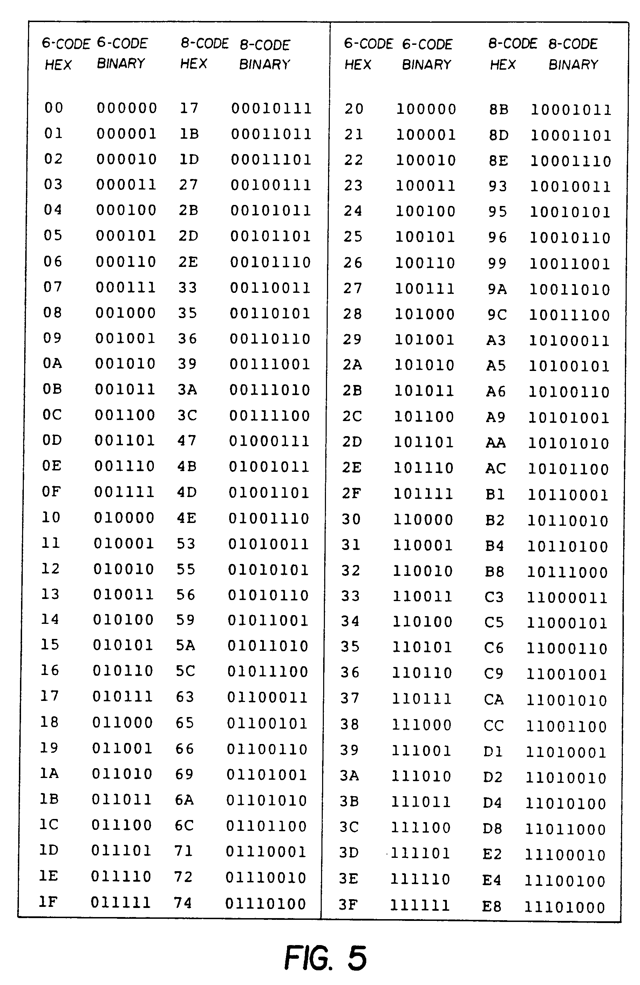

As will be explained hereinbelow, when the film bits are to read or played back while the film is projected, distinguishing among the film bits in a given horizontal film bit row and maintaining symbol boundaries within the row is facilitated in the invention by encoding the data to be recorded as film bits in such a manner as to maximize the occurrence of alternating zeroes and ones (e.g., clear and opaque film bits) across each horizontal row. However, this must be done without disturbing the information content of the data stream. In order to meet this requirement, the six-bit codeword symbols generated by the encoder 302 are applied in sequence to a 6-to-8 encoder programmable-read-only-memory (PROM) 304, which in turn produces a unique 8-bit symbol for each 6-bit codeword symbol received. The contents of the PROM 304 are illustrated in Fig. 5. The PROM 304 converts each 6-bit symbol to a unique 8-bit symbol whose weight is equal to 4--i.e., there are always four zero-value bits and four one-value bits in each eight-bit symbol. It so happens that there are only 64 six-bit symbols, which is less than the number of eight-bit symbols of weight four. As a result, the PROM 304 provides a unique eight-bit symbol for each six-bit codeword symbol, thus avoiding any ambiguity.

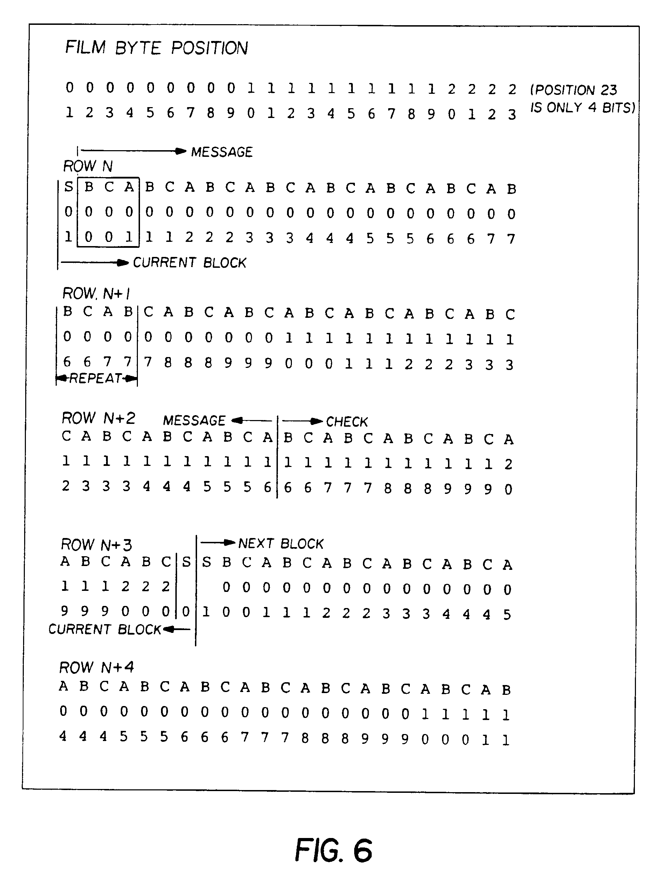

Fig. 6 illustrates as a function of film bit position the encoded codeword block produced by the PROM 304. The number of symbols (63) is divisible by 3, and therefore every third symbol in each block is labelled either A, B or C in Fig. 6. Following the leading sync symbol (labelled S01) the most significant bits of the second, third and fourth message bytes (labelled B00, C00 and A01, respectively) are the three control bits inserted by the encoder 302. Fig. 6 illustrates the boundary of the messages symbols, the check symbols and the locations of the leading and trailing sync symbols (labelled S01 and S 0, respectively). It will be remembered that the leading sync symbol is one of the codeword symbols while the trailing sync symbol is not included in the codeword.

Encoding to Maximize the Number of Useful Bit Transitions in the Vertical Direction

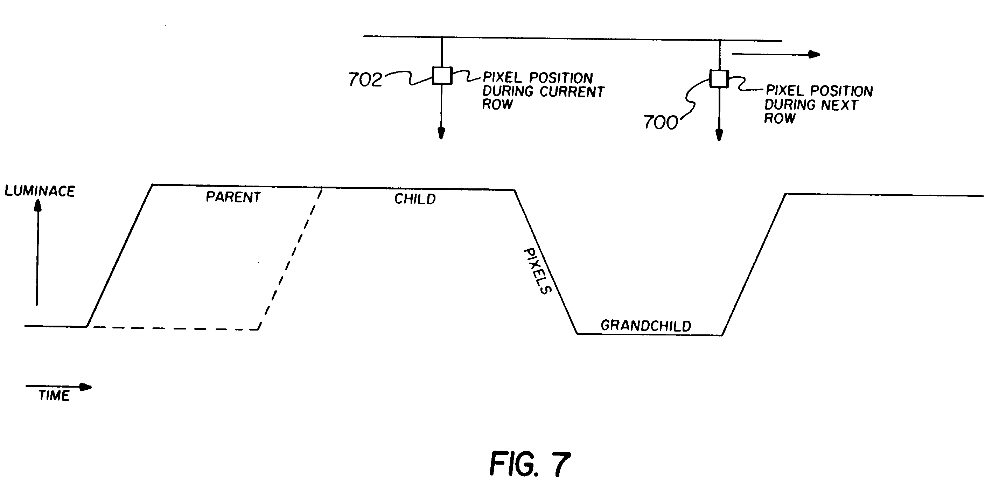

The luminance sensed by the CCD image sensor pixel 104a of Fig. 1 as the film 102 is transported in the projector is illustrated as a function of time in the graph of Fig. 7. If the image sensor 200 is at least nearly synchronized with the actual passage of the centers of successive film bit rows, then pixel positions 700 and 702 represent the occurrence of successive "snapshots" taken by the image sensor 200 at the pixel 104a. Note that the successive film bit luminance values in the film bit column underlying the pixel 104a "fall-off" near the film bit boundaries, because each film bit occupies less of the field of view of the CCD pixel as its center moves away from the pixel.

In the invention, the image sensor is synchronized with the passage of successive film bit rows by tracking the difference between successive film bits. Thus, in effect, the luminance values obtained at the successive sampling times corresponding to the pixel positions 700 and 702 of Fig. 7 are subtracted. However, it should be readily apparent to the alert reader that unless the parent and grandchild film bits (as labelled in Fig. 7) represent opposite binary values, such a subtraction cannot distinguish film bit transitions. Thus, if the dashed line waveform of Fig. 7 is substituted instead of the solid line waveform, subtraction of successive luminance values would yield virtually no information.

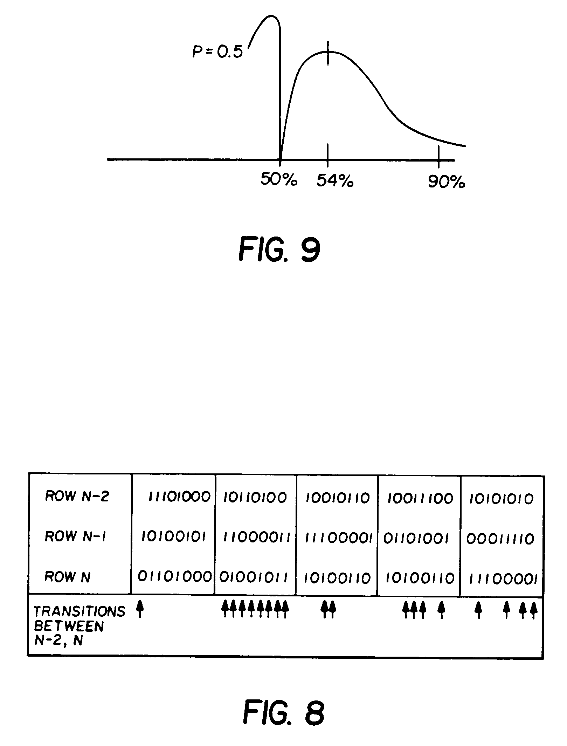

The problem is illustrated in Fig. 8, in which three successive rows of film bit data are shown in the relative location in which they are recorded on the film. Those columns having useful film bit transitions (in which the parent and grandchild bits differ) are indicated by arrows. In this example, only some of the 40 columns shown have useful transitions. The goal is to increase the number of useful transitions so that they occur in greater than 50% of the columns.

This problem is solved in the invention by transforming each grandchild codeword so as to maximize the number of film bit transitions for which the parent film bit is different from the grandchild film bit within the same vertical film bit column. This results in a probability distribution of useful film bit transitions in which the median occurrence of useful film bit transitions is 54% and is never below 50%. However, such an inversion must be reversible upon playback so that the information content of the data is not lost.

For this purpose, the palindromic or symmetrical nature of the code (discussed previously herein) is exploited. In such a code, a codeword is separable into sub-codewords of equal length, which in the case of RS(63,49) codewords is 21 symbols long, there being three sub-codewords in this example. Each sub-codeword comprises every third symbol of the codeword in this example. Thus, referring to Fig. 6, every third symbol labelled A lies in one sub-codeword, every third symbol labelled B lies in a second sub-codeword and every third symbol labelled C lies in the third sub-codeword. Each sub-codeword may be inverted and the resulting overall codeword is another codeword of the code. In the case of an RS(63,49) codeword having three sub-codewords, there are eight distinct ways in which the codeword may be inverted. In order to ensure that the inverted codeword is re-inverted back to the original codeword, the three control bits inserted as the most significant bits of the symbols B00, C00 and A01 are initially zero and are each inverted as the corresponding sub-codeword B, C and A is inverted. These control bits thus provide all the information required to re-invert each codeword upon playback and decoding to recover the encoded information.

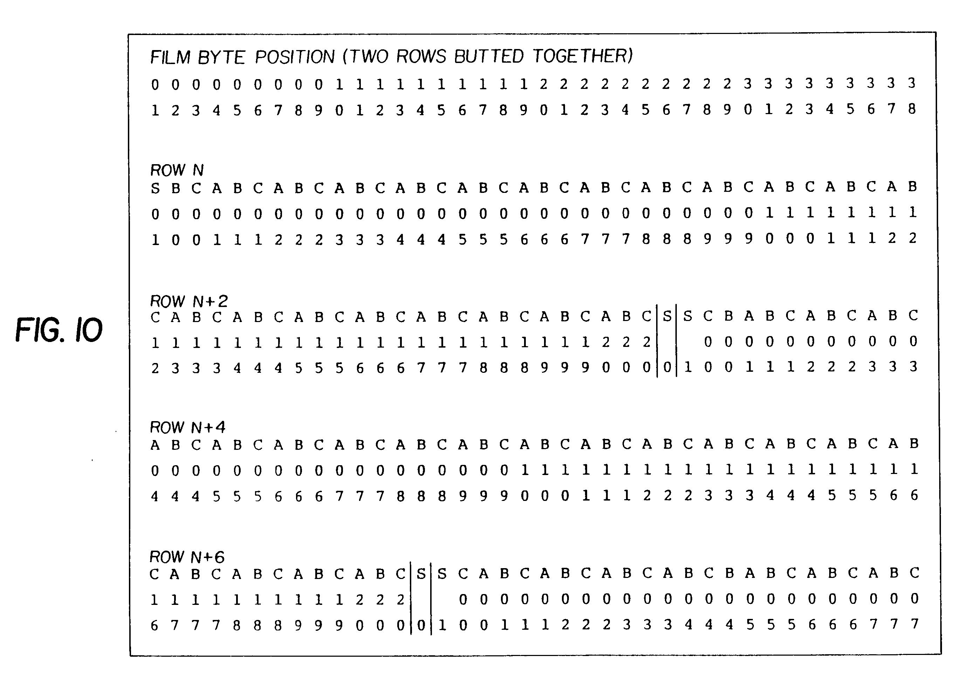

Organization of the film bit data in Fig. 10, in which two rows of film bits are butted together in successive double rows, so that the comparison between parent and grandchild film bits is readily made. Such an organization of the data is made by using a two-row delay circuit (such as a memory) 306. The output of the PROM 304 is applied to the input of the two-row delay 306 and to a grandchild input of a sub-codeword inverter 308. The output of the two-row delay 306 is applied to a parent input of the sub-codeword inverter 308.

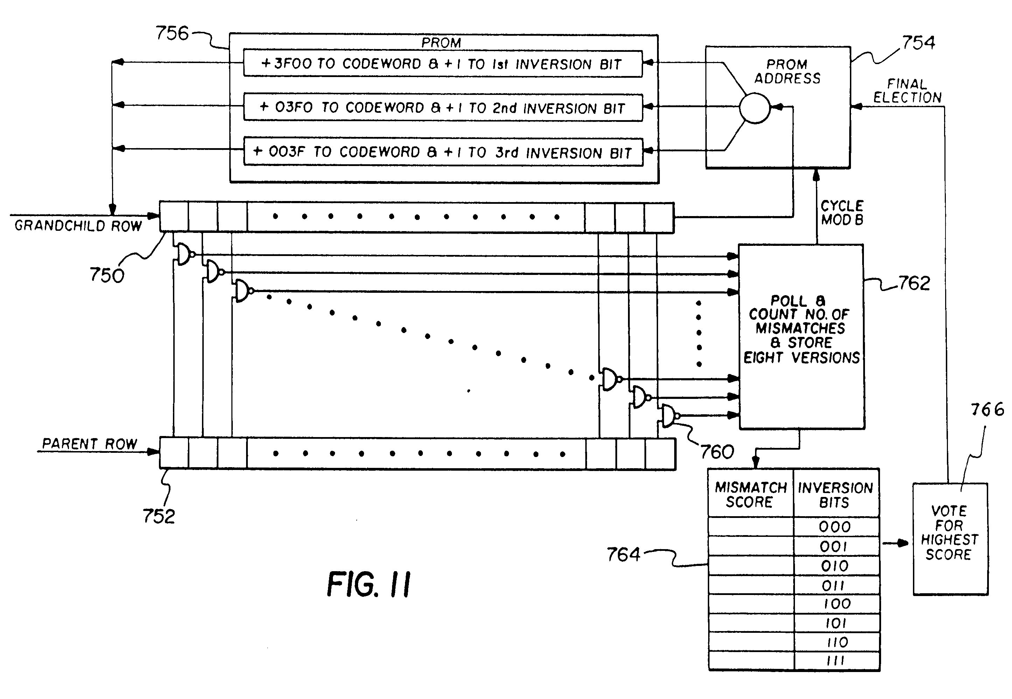

The sub-codeword inverter 308 is illustrated in Fig. 11. The grandchild film-bit data row is held in a grandchild register 750 while the parent film bit data row is held in a parent register 752. Continuing with the example of an RS(63,49) code, the eight possible inversions of the grandchild codeword stored in the grandchild register 750 are generated by applying the contents of the grandchild register 750 to the address input 754 of a codeword inversion PROM 756. In the present example, sub-codeword A is inverted by simply adding the pattern 3F 000 000 (in hexidecimal) to the codeword, the sub-codeword B is inverted by adding the pattern 000 3F 000 and the sub-codeword C is inverted by adding 000 000 3F. The PROM 756 stores the results of the eight possible permutations of such additions for all 64 possible codewords. In the stored results, the three control bits are inverted as corresponding ones of the sub-codewords are inverted. Thus, by addressing the PROM 756 with the contents of the grandchild register 750, eight possible inversions of the codeword are loaded into the grandchild register 750 in succession and individually compared with the contents of the parent register 752 by a logic network of NAND gates 760 connected between corresponding bits of the two registers. The outputs of all of the NAND gates 760 are polled by a poll logic circuit 762, which counts the number of mismatched bits between the parent and grandchild registers 752 and 750. The poll logic circuit is connected to a memory 764 which stores this number as a score, so that a score is kept for each of the eight possible inversions of the grandchild codeword. A logic circuit 766 detects which version has the highest score and declares that version as the winner to the address input 754 of the PROM 756. The corresponding inversion of the codeword is then loaded by the PROM 756 into the grandchild register 750. This selected inversion is then transmitted by the sub-codeword inverter 308 to a demultiplexer 310 of Fig. 3 and hence to an optical recorder light emitting diode (LED) array 312 for recording of the serial stream of digital bits as film bits on the film 102.

While the preferred embodiment of the invention has been described with respect to an example in which the 6-to-8 encoding is performed prior to selective codeword inversion, the order of these two processes may be reversed and the same result is obtained. The order in which these two processes is performed therefore may be changed by the skilled worker as desired.

Decoding System

After the encoded data has been thus recorded on the film, it must eventually be read back and decoded. A decoding system which reads the data from the film and decodes it is illustrated in Fig. 12. The decoding system is included as part of a film projector 800 which transports the film 102 through a film gate illuminated by a high intensity light source 802. The system further includes a CCD array system 804 (image sensor) comprising the linear CCD array 200 of image sensing pixels shown schematically in Fig. 2. The CCD system 804 causes the CCD array to take a "snapshot" of the film sound stripe 100 (shown in Fig. 1) in synchronism with a row clock signal SCANCLK. This clock signal is generated by a row clock generator 806. The selection of those individual CCD pixels lying closest to the centers of respective film bits is made by a data desmearer 808 in accordance with the contents of a phase word register 810b maintained by a microprocessor 810a of a phase word generator 810. The data desmearer 808 outputs binary data bits in accordance with the resemblance of respective film bits to clear (binary 0) or opaque (binary 1) squares in the film. The data desmearer 808 also outputs an erasure flag for each bit corresponding to a film bit which did not sufficiently resemble either a clear or opaque square on the film. An 8-to-6 converter converts the eight-bit encoded symbols to six-bit RS(63,49) symbols. Prior to this conversion, symbol boundaries are checked or corrected by the desmearer 808 by sensing which of eight possible periodic symbol boundaries in the stream of eight-bit symbols provides the requisite symbol weight. A codeword sync acquisition circuit 814 detects the presence of the leading and trailing sync symbols to synchronize a forward error corrector 816 so that it grabs each incoming codeword as it is received from the 8-to-6 converter 812. The forward error corrector 816 employs the erasure flags as error location symbols in decoding and correcting the received codeword. The forward error corrector 816 takes advantage of the corrections performed by the desmearer 808 and the 8-to-6 converter 812 by first verifying their efficacy and then deregarding corresponding erasure flags.

## Row Clock Generator

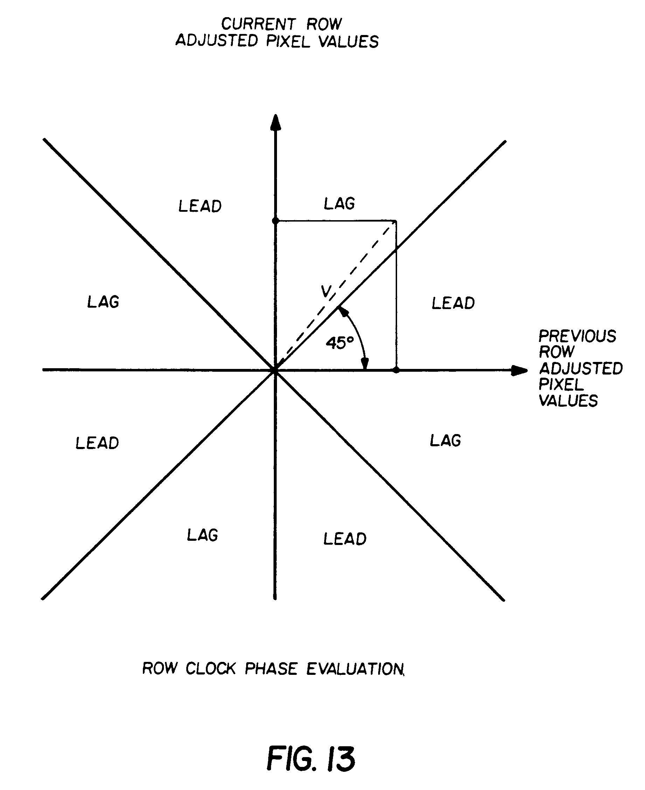

Making sure that the linear sensor array 200 is centered over the center of each successive horizontal film bit row whenever the row clock signal triggers a "snapshot" by the array 200 is the job of the row clock generator 806. The principle behind its operation is illustrated in Fig. 13. For film bit transitions that meet the criteria Fig. 7 (i.e., the parent and grandchild film bits in a given column differ) a conclusion may be drawn as to whether the CCD array 200 is being triggered by the row clock signal slightly ahead of the center of the current row ("lead") or slightly behind it ("lag"). The vertical axis is the algebraic difference between the luminance of a given pixel in the current row and the average luminance across all pixels in the current row. The horizontal axis is the algebraic difference between the luminance of the same pixel in the previous row and the average luminance across all pixels in the previous row. A vector such as the vector V illustrated in Fig. 13 specifies a pair film bit values of current and previous film bit rows within a given film bit column. Each quadrant of the graph of Fig. 13 is divided along a 45 degree bisector, all vectors lying in one half of the quadrant indicating a "lead" condition and all vectors lying in the other half indicating a "lag" condition. If a vector lies along one of the 45 degree bisectors, no information regarding the timeliness of the row clock signal can be gleaned.

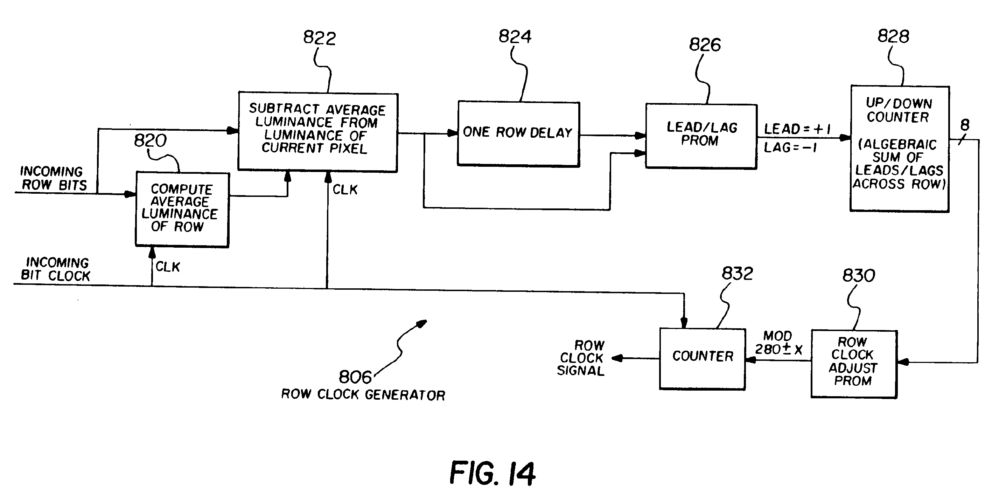

The row clock signal which triggers each "snapshot" taken by the CCD imaging array 200 is regulated in accordance with the foregoing principles by the row clock generator 806 of the decoding system of Fig. 12. The row clock generator 806 is illustrated in the functional block diagram of Fig. 14.

Referring to Fig. 14, an adder/accumulator function 820 receives from the CCD array system 804 the luminance values of all the film bits in the current film bit row and computes the average luminance across the entire row. A subtractor function 822 subtracts the average luminance from the luminance values of each film bit in the row and transmits the resulting "normalized" luminance values to a one-row delay function 824 and to one address sub-port of a lead/lag PROM 826, one film bit at a time. Simultaneously, the lead/lag PROM 826 receives at another address sub-port the corresponding normalized luminance values of the previous film bit row from the one-row delay function 824, one film bit at a time. Together, the two address sub-ports comprise the address port of the lead/lag PROM 826.

The lead/lag PROM 826 implements the diagram of Fig. 13. For this purpose, it stores for all possible combinations of luminance value pairs of the current and previous film bit rows the appropriate lead or lag indications in accordance with the diagram of Fig. 13. For each film bit pair across one row, the lead/lag PROM transmits either a lead or lag or "hold" (do nothing) indication to an up/down counter 828. The contents of the up/down counter 828 is reset at the beginning of each film bit row. The up/down counter 828 counts up one or down one in response to each lead or lag command, respectively, received from the lead/lag PROM 826. As soon as the lead/lag PROM 826 has processed all the film bits of the current row, the up/down counter 828 contains the algebraic sum of all lead and lag conditions of the current row, which is a reliable indication of whether the row clock signal actually leads or lags the coincidence in time of the center of the current film bit row with the linear CCD imager array 200 of the CCD array system 804. The contents of the up/down counter 828 is applied to the input of a row clock adjustment PROM 830. The row clock adjustment PROM 830 responds by producing a binary number equal to the number of clock cycles N normally required by the CCD imager system 804 to cycle and refresh all of its pixels in the well-known fashion (typically 280) plus a positive or negative number x (typically +5 or -5). Whether x is positive or negative depends upon whether the contents of the up/down counter 828 indicates a preponderance of lead or lag conditions, respectively, for the current film bit row. This binary number is then employed as the modulus of a counter 832 whose output is the row clock signal controlling the CCD array system 804. The row clock adjustment PROM correlates all possible values which the contents of the up/down counter may assume to either N+x or N-x as appropriate, in accordance with the foregoing description. The PROM's 826 and 830 are readily programmed by the skilled worker in accordance with the foregoing description.

## Phase Word Generator

While the row clock generator 806 assures that the CCD array 200 is triggered in the middle of the current film bit row, thus centering each image sensor pixel with respect to the film bit rows in the vertical direction, it is also necessary to select those image sensor pixels most nearly centered in the horizontal direction with respect to the film bits. Such a selection is controlled by the phase word generator 810 of the decoding system of Fig. 12.

The phase word generator 810 employs an angular coordinate system for specifying the horizontal location along the linear imager array 200 (illustrated in Fig. 2) with respect to the film bit locations. This angular coordinate system is illustrated in Fig. 2. The horizontal position is denoted $\psi$ and is expressed in units in which the width W of one film bit is defined as unity. The width w of each CCD imaging pixel in the linear array 200 (which is presumed to be the same for all such pixels) is denoted $\Delta\psi$, and is expressed in the same units wherein the width W of one film bit is defined as unity. For the exemplary system, there are about 512 CCD pixels in the linear array 200 spanning about 161 film bits (although this may vary depending upon the hardware design and the area of the film bit photographically recorded on the film), so that $\Delta\psi = .3$ approximately, as indicated in Fig. 2. It should be apparent that the fractional part of $\psi$ (or $\psi$ mod 1) equals .5 at the center of each film bit. The displacement between the inside edge 100a of the sound strip 100 and the leading pixel (pixel #0) of the array 200 is denoted $\psi_0$, which in the example of Fig. 2 is .525 (i.e., about half a film bit width). As will be seen below in connection with the desmearer 808, the locations of the centers of each of the pixels in the linear array 200 expressed in terms of the angle $\psi$ are known. The goal, then, is to always know the value of $\psi$ at the center of each film bit so that the desmearer 808 may select for each film bit the CCD pixel most nearly centered over the film bit, despite lateral wandering of the film with respect to the linear array 200.

This goal is met recognizing that:

(a) $\sin 2\pi\psi$ and $\cos 2\pi\psi$ are periodic across each film bit row,

(b) if $d_n$ and $d_{n-1}$ are the luminance values of the current and previous film bits, respectively, within the same horizontal row, then, referring to Fig.'s 15a, b, c and d, the cumulative sums across many film bits in the same row of:

$$(1.) \qquad s_n = |d_n - d_{n-1}| \sin 2\pi\psi$$

and

$$(2.) \qquad c_n = |d_n - d_{n-1}| \cos 2\pi\psi$$

are very small and very large, respectively, if the angular error A (depicted in Fig. 15) between the estimated horizontal location $\psi_n^{(reg)}$ of the center of the $n^{th}$ film bit and the actual location on film $\psi_n^{(film)}$ of the center of the $n^{th}$ film bit is small. This is in part due to the selection of the eight-bit symbol weight of four. (As discussed previously herein, the selection of weight four was made to enhance the horizontal alignment control.)

One way of estimating the angular error A to within a fraction of the width W of one film bit is illustrated by the chart of Fig. 16. In this chart, the following definitions use the quantities discussed above:

$$(3.) \qquad C = C_{i,j} = \sum_{n=i}^{j} c_n,$$

$$(4.) \qquad S = S_{i,j} = \sum_{n=i}^{j} s_n.$$

The angular error A may be estimated by computing:

$$(5.) \qquad A = A_{i,j} = (1/2\pi) \arctan (S_{i,j}/C_{i,j}),$$

where $n = (i + j)/2$.

Fig. 16 shows how to estimate A to within an error of one-sixteenth of a film bit width W by simply determining (a) which one of S and C is the greater, (b) whether their sum is a negative number, (c) whether their difference is negative number and (d) whether each of them is a positive or negative number. Thus, in one alternative embodiment of the invention, the phase word generator 810 performs the computations in a microprocessor 810a of equations (1.) through (4.) above to determine S and C . The microprocessor 810a then performs the tests (a) through (d) above to estimate the angular error A in accordance with the chart of Fig. 16. The microprocessor 810a then changes the values of $\psi$ and $\Delta\psi$ stored in a phase word register 810b to compensate for the error. A slightly more accurate version of this approach is illustrated in Fig. 17.

In the preferred embodiment of the invention, however, the microprocessor 810a (or its equivalent in dedicated logic circuits) performs the algorithm depicted in the flow chart of Fig. 18. In this algorithm, the microprocessor maintains the definitions of equations (1.) through (5.) above in blocks 840, 842 and 844. It further defines the partial sums of block 846 and block 848. The microprocessor 810a then performs the computations of block 850 using the partial sums defined previously in the preceeding blocks to produce an average correction $D_{av}$. The microprocessor 810a then employs the average correction $D_{av}$ to update the values $\psi^{(reg)}$ and $\pi\psi^{(reg)}$ stored in the phase register 810b by performing the computations of block 852.

While the partial sum algorithm of Fig. 18 continuously monitors the angular errors at the $64^{th}$ film bit position in the row (as can be seen from the computations depicted in Fig. 18), any other film bit position not too near the sound stripe edges may be selected for the algorithm.

Data Desmearer

The first task of the data desmearer 808 of the decoding system of Fig. 12 is to use the angular values $\psi$ and $\pi\psi$ currently stored in the phase register 810b to choose only those pixels in the linear array 200 which are most nearly centered in the horizontal direction over respective film bits in the current horizontal film bit row. The data desmearer 808 does this by performing the process illustrated in the block diagram of Fig. 19. (For this purpose, the data desmearer 808 may be either a programmed microprocessor or dedicated logic hardware, either of which is readily adapted by the skilled worker to perform the process of Fig. 19.)

At the beginning of each row (signified by the row clock signal changing state), the value of $\psi$ is initialized to $\psi_0$, which is stored in the phase word register 810b and is the distance between a reference point such as sound stripe edge and the center of the first pixel in the linear array, as illustrated in Fig. 2. This initializing step is depicted in block 860 of Fig. 19.

The new value of $\psi$ is then computed by adding $2\pi\psi$ (taken from the phase word register 810b) to the old value (block 862). A determination is then made as to whether this change in $\psi$ changes the non-fractional bits of $\psi$ (block 864). If not, the next film bit has not been reached and therefore $\psi$ must be incremented again ("NO" branch of block 864). Otherwise, the desmearer 808 grabs the luminance value of the next odd-numbered pixel in the linear array 200 (block 866). The desmearer 808 knows how to do this because it knows the location value $\psi$ of the center of each pixel in the array 200, as illustrated in Fig. 2.

A determination is then made whether the fractional part of $\psi$ is less than .375 (block 868). (It should be noted this value depends upon the number of film bits per horizontal row and the number of CCD imager pixels spanning the row, which in the present example is approximately 161 and exactly 512, respectively.) Depending upon the outcome of this determination, the desmearer 808 grabs the luminance value of either the next or the previous even numbered pixel in the array 200. The object here is to select two adjacent pixels horizontally spanning the center of the current film bit. A weighted luminance value $d_n'$ is then computed from the luminance values $d_{n\ odd}$ and $d_{n\ even}$ of the odd and even pixels which have now been grabbed. The weighting is based upon the relative proximity of each of the two pixels to the center of the film bit, such that if one of the two pixels is directly centered over the film bit, the other pixel is completely ignored, while if the two pixels symmetrically span the film bit, they are weighted equally.

Such a weighting process is shown in blocks 874a, defining the weight of the odd pixel luminance value, 874b, defining the weight of the even pixel luminance value and 874c, depicting the computation of the weighted luminance value from the odd and even luminance values.

The weighted luminance value $d_n'$ is then compared with predetermined luminance values $d_0$ and $d_1$ characteristic of a pixel centered over a clear (zero) or opaque (one) film bit, and a binary zero or one data bit is transmitted depending upon whether $d_n'$ is closer to $d_0$ or $d_1$, respectively (block 878). Then, if the weighted luminance value $d_n'$ is not sufficiently close to either $d_0$ or $d_1$ to within a predetermined threshold, the desmearer 808 transmits an erasure flag bit = 1 along with the data bit (block 880). The predetermined threshold may be set such that an erasure flag bit is transmitted whenever $d_n'$ is not within 33% of either $d_0$ or $d_1$. The luminance values $d_0$ and $d_1$ are readily predetermined by the skilled worker by simply noting the luminance values of CCD pixels centered over clear and opaque film bits, respectively.

The process of Fig. 19 then returns to block 862 to update $\psi$ using the latest value of $\delta\psi$ stored in the phase word register 810b, and the foregoing cycle is repeated until the end of the current horizontal film bit row is reached.

First Level Error Correction, Symbol Sync Detection and 8-to-6 Conversion Channel Decoding by the Data Desmearer

Another aspect of the data desmearer 808 is illustrated in the schematic block diagram of Fig. 20. The circuit of Fig. 20 takes advantage of the 6-to-8 channel encoding performed by the 6-to-8 encoder PROM 304 of the encoder system of Fig. 3 and of the erasure flag bits produced in accordance with the process of Fig. 19 to correct and maintain symbol-to-symbol boundaries and to perform a first level error correction process.

Referring to Fig. 20, the data bits produced in the step of block 878 of the process of Fig. 19 are stored sequentially in an eight-bit data register 890 while the corresponding erasure flag bits produced in the step of block 880 of the process of Fig. 19 are stored in corresponding locations in an erasure flag register 892. The contents of the data register 890 are applied to the address input of a weight=4 PROM 894. The PROM is programmed so as to transmit a one-bit only if the eight bit sequence in the data register has a weight of four. It will be recalled that the 6-to-8 encoder PROM 304 of the encoder system of Fig. 3 mapped each 6-bit RS(63,49) symbol to a unique 8-bit symbol of weight four (i.e., number of one-bits equals four in each 8-bit symbol). It will be further recalled that the reason given hereinabove for performing such a channel encodement was to enhance the horizontal direction synchronization or centering, performed by the phase word generator 810 in accordance with the process of Fig. 18. However, as will be seen hereinbelow, the 6-to-8 channel code provides additional advantageous functions.

Symbol Boundary Control:

The output of the weight=4 PROM 894 sets a flip-flop 896 controlling one address bit of a scoring PROM 898. The scoring PROM 898 is part of a symbol boundary control loop 900, including a score random access memory (RAM) 902, an input latch 904, an output latch 906, an output flip flop 908, a comparator 910 and a modulus eight (mod 8) counter 912. The number of bits at each input and output of each of the foregoing elements of the symbol boundary control loop 900 is indicated in Fig. 20.

The symbol boundary control loop 900 operates as follows. With each shift of the data register 890, the weight=4 PROM 894 causes an enabling signal to be applied to one address input of the score PROM 898 if the eight-bit data sequence stored in the data register does not have weight four. If such an enabling signal is received, the scoring PROM 898 decrements the current one of eight six-bit locations in the score RAM 902 by one. Otherwise, the scoring PROM 898 increments this location by two. Then, with the next shift of the data register 890, the mod-8 counter 912 addresses the next one of the eight locations in the score RAM 902 and the process is repeated. With each such cycle, the score RAM 902 informs the scoring PROM 898 of the score in the current memory location. As soon as the scoring PROM 898 receives a score of 63, it declares the current cycle of the mod-8 counter to be the "winner"--i.e., the current cycle defines the proper boundary between successive eight-bit symbols in the data bit stream received by the data register 890. This cycle number (a three bit number) is stored in the latch 906. Then, as each winner is declared by the scoring PROM 898, the comparator compares the current cycle of the mod-8 counter 912 with the cycle of the previous winner (the contents of the latch 906). If there is a match, this means that the symbol boundary has not changed since the previous symbol and therefore there has been no detected symbol boundary error. Therefore, the comparator 910 enables a serial-to-parallel flip-flop 914 at the output of the data register 890 so that the current contents of the data register is output as an eight-bit symbol. If there is a mismatch, however, the comparator 910 causes a mute flag to be transmitted by a logic gate 916. This mute flag identifies the current symbol to the forward error corrector 816 of Fig. 12 as being one in which the symbol boundary is incorrect and therefore as a useless symbol. As will be explained hereinbelow, this mute flag warns the forward error corrector that the entire codeword may not be correctable, due to the loss of symbol synch, and should therefore be muted. In this case, the user may perform other procedures. For example, if the data represents digital audio data, the user may fill in for the muted codeword by performing audio interpolation.

After declaring a "winner", the scoring PROM 898 prevents overly frequent changes to the symbol boundary by preventing the score of any other one of the eight memory locations from increasing, although any score is allowed to decrease, including the score of the "winner". If the winner's score decreases below the maximum (63), then there is no declared "winner" and any score is allowed to advance in the manner described above. This latter feature is implemented by the connection between the output of the comparator 910 and the flip-flop 908. The output of the flip-flop 908 is connected to an address input of the scoring PROM 898 so as to disable the PROM 898 from advancing the scores stored in the score RAM 902 as long as the current declared winner is the same as the previous declared winner.

First Level Bit Error Correction:

As soon as the serial-to-parallel flip-flop 914 is enabled, the eight bits stored in the serial data register 890 are simultaneously applied through an arithmetic logic unit (ALU) 918 to eight parallel address bit inputs of a correcting weight=4 PROM 920. The correcting weight=4 PROM 920 determines whether the weight of the eight bits is four. If so, this indicates that the eight bits are most likely correct and can therefore be transmitted "as is" to the forward error corrector 816. However, if the weight is not equal to four, then the PROM 920 transmits inverting flag through a latch 922 to the ALU 918. In response, if the weight was less than four, the ALU 918 attempts to correct individual bits stored in the data register 890 by logically ORing them with corresponding bits stored in the erasure flag register 892. On the other hand, if the weight is greater than four, the ALU 918 AND's each of the bits stored in the data register 890 with corresponding bits in the erasure register 892, these latter results being applied to the PROM 920. The results of this correction attempt are then transmitted to the eight address inputs of the PROM 920, which again determines whether they are of weight four. If the weight is now found to be four, then the attempt has succeeded and the eight bit symbol is converted by the PROM 920 to the corresponding six-bit symbol for transmission to the forward error corrector 816. Otherwise, if the symbol weight is still not four, the correction attempt has failed. At this point, no further correction attempts are made by the ALU 918. Instead, the PROM 920 issues an erase flag to the forward error corrector 816. The forward error corrector 816 responds to this erase flag by treating the current symbol as an erasure.

The skilled worker may readily implement the foregoing functions in the data desmearer 808 by appropriate logic circuitry 924 and an appropriately programmed output PROM 926 connected to the PROM 920 as illustrated in Fig. 20. In summary, the data desmearer 808 provides the forward error corrector 816 with either a six-bit symbol, or a symbol erasure flag or a mute flag.

Erasure Processing by the Forward Error Corrector

The forward error corrector 816 performs the error correction required to recover the information (e.g., digital audio) bits from each RS(63,49) codeword, using well-known techniques. The codeword is delineated by the leading and trailing sync symbols discussed previously herein in connection with Fig. 6 and comprises 63 six-bit symbols received in succession from the data desmearer 812. The delineation of the codeword is performed by the codeword sync acquisition circuit 814 using techniques well-known in the art.

Generally, the forward error corrector employs a Reed-Solomon decoder algorithm which can correct the codeword as long as the sum of the number of erasures (errors of known locations) and twice the number of error (of unknown locations) does not exceed r, the number of check symbols in the codeword, which in this case is 14. However, it is desirable to limit this sum to a number h less than 14 in order to reduce the probability of the decoder performing a mis-decode. h may be on the order of 10 or 12 in the present example of RS(63,49). The forward error corrector does this in a manner which optimizes the decoding correction performance, in accordance with the error correction process illustrated in Fig. 21.

Referring to Fig. 21, the number S of symbols in the present codeword received from the data desmearer 808 which are accompanied by erasure flags issued by the PROM 926 of Fig. 20 is determined (block 930). If S is not less than r, rather than discarding the codeword as undecodable in accordance with conventional techniques, the forward error corrector 816 instead first assumes that some of the erasure flags were erroneously issued and therefore tries to decode the codeword as if there were no erasures (block 934). If it finds the codeword is decodable (block 936), it outputs the decoded/corrected codeword (block 938). Otherwise, it issues a mute flag to the user, signifying that the codeword is undecodable (block 940).

On the other hand, if S is less than r, then the forward error corrector 816 decodes the codeword using all of the erasure flags as erasure locations (block 942). If the codeword is not decodable, the forward error corrector 816 issues a codeword mute flag to the user (block 945). If the codeword is decodable (block 944), the forward error corrector 816 determines how many of the 63 codeword symbols accompanied by an erasure flag were error-free. This number is then subtracted from S (the number of apparent erasures, discussed above) to obtain the number of true erasures $S'$ (block 946). Also, the number of erroneous symbols found which were not accompanied by an erasure flag is determined. This number is the number of actual errors $t'$. A more rigorous test is now applied by demanding that $S' + 2t'$ not exceed h (block 948). If the test is met, the decoded/corrected codeword is transmitted to the user (block 950). Otherwise, the mute flag is transmitted (block 945).

An alternative embodiment of the foregoing process is illustrated in Fig. 22, the basic difference being that there are no errors in the process of Fig. 22.

## Claims

1. A system for processing a stream of digital data with respect to a data channel, said stream of digital data being encoded into successive codewords each comprising n m-bit symbols belonging to an error correction code, said successive codewords being recorded in a physical format (100) on a recording medium (102), the format consisting of rows (106) transverse to the recording direction and columns (108) extending in the recording direction, said system being characterized by:

first encoder means (302) for encoding said stream of digital data into said successive codewords each comprising n m-bit symbols belonging to said error correcting code, and for adding synchronization symbols and control bits to selected positions of the codeword;

second encoder means (304) for encoding each of said m-bit symbols so as to produce m + z-bit symbols in accordance with a channel code, said channel code being characterized in that each of said m + z-bit symbols are of weight w;

inverting means (306, 308) for dividing said successive codewords into successive row groups of M bits, each of said successive row groups comprising at least some of the symbols of said successive codewords, said row groups having commonly aligned bit positions,

and for separating said codewords into a selected number of sub-codewords of equal length and producing related codewords by selectively inverting ones of said sub-codewords so as to maximize the number of bit positions in each of said row groups which contain bits different from those in alternate ones of said row groups, whereby said selected inversions are marked by said control bits and said related codewords are still codewords for which said error correction code is valid; and

means (312) for transmitting analog signals to said channel representing the channel encoded symbols corresponding to the codewords processed by said inverting means (306, 308), wherein said analog signals comprise analog values organized into successive rows (106) of M analog value sites (104) corresponding to the M bits of said successive row groups.

2. The system of Claim 1, further comprising:

analog signal acquisition means (200) comprising M+N sensors (202) for sensing the analog values at each of said M sites (104) of each one of said successive rows (106);

row clock generator means (806) for synchronizing said analog signal acquisition means (200) with each one of said successive row groups in accordance with a vector sum for each of said rows (106) of differences between pairs of successive analog values sensed at individual ones of said sensors (202);

data desmearer means (808) for:

selecting from said M+N sensors (202) at least M sensors which are at most nearly in registration with said M sites (104) for each one of said successive rows (106), and

transmitting:

a data bit based upon the closeness of the analog value sensed by each one of said selected M sensors to one of two predetermined analog values corresponding to binary values of one and zero, respectively, and

an erasure bit for each one of said data bits for which the sensed analog value is beyond a predetermined threshold distance of either one of said predetermined analog values;

symbol boundary control means (890, 900) for selecting about every $(m+z)^{th}$ one of said data bits as the first bits of successive m+z-bit symbols so as to maximize the number of said m+z-bit symbols having weight w, and for producing the corresponding m+z-bit symbols;

channel decoding and first level error correction means (808), comprising:

means (918) for inverting those of said data bits having corresponding erasure bits from said desmearing means whenever the corresponding m+z-bit symbol produced by said desmearing means is not of weight w to produce an altered symbol, and

means (926) for transmitting a symbol erasure flag whenever said altered symbol is not of weight w; and

means (812) for channel decoding either (a) said symbol produced by said desmearing means or (b) said altered symbol, to produce a corresponding m-bit symbol; and

error correction means (816) for acquiring n ones of the six-bit symbols produced by said channel decoding means (812) and decoding said codeword.

3. The system of Claim 2 wherein said data desmearer means (808) for selecting M sensors comprises:

phase word generator means (810) for computing partial sums of the product of (a) the difference between the analog values of one site (104) and its predecessor in the row and (b) a tangent-like function of an angle $\psi$ representing the position of said sites (104) with respect to said sensors (202) in numerical units in which the pitch between said sensors is unity; and

correction means (810a) for computing the location with respect to said sensors (202) of the centers of each of the sites (104) in a row.

4. The system of Claim 3 wherein said correction means comprise:

means (810a) for computing from said partial sums the change in said angle $\psi$ between adjacent ones of said sensors (202);

means (808) for computing from said partial sums the position of the first one of said sensors (202) with respect to the first one of said sites (104);

means (808) for incrementing $\psi$ by $k\pi\psi$, where k corresponds approximately to the number of sensors for each site.

5. The system of Claim 2 wherein said data desmearing means (808) for transmitting said data bit comprises means for weighting analog values of pairs of said sensors spanning the center of respective ones of said site in proportion to their proximity to said center.

6. The system of Claim 2 wherein said symbol boundary control means (890, 900) comprises means (898) for maintaining a score for each of m+z possible bit positions for the first bit of each symbol, and for incrementing said score whenever the corresponding m+z-bit symbol has weight w and decrementing said score whenever the corresponding m+z-bit symbol does not have weight w, and for declaring a winning bit position whenever the corresponding score is at least nearly a predetermined threshold score.

7. The system of Claim 6 wherein said predetermined threshold score is at least nearly $2^{m+z-1}-1$.

8. The system of Claim 6 wherein said means (898) for maintaining a score decrements said score by one and increments said score by two.

9. The system of Claim 2 wherein said error correction means (816) comprises:
   error sensing means for sensing a lack of any errors in each symbol accompanied by an erasure flag;
   codeword mute flag transmitting means for determining whether the number of erasure flags for a given codeword minus the number of erasure flags for which no error was found by said error sensing means exceeds a threshold number h less than the number of redundant check symbols in said codeword.

10. The system of Claim 9 wherein said error sensing means further senses the number errors of any location in said codeword and wherein said mute flag transmitting means adds to the number of erasures the number of errors sensed by said error sensing means.

11. The system of Claim 2 wherein:
   said means for transmitting analog signals comprises means (312) for photographically recording opaque (104b) and clear (104a) sites on a strip of film (102), wherein said row groups comprises horizontal rows (106) of said sites (104) on said film (102); and
   said means for acquiring said analog signal comprises a linear array (200) of image sensors corresponding to said M+N sensors (202), said array being generally aligned in the direction of said horizontal rows (106).

12. The system of Claim 1 wherein the number of said sub-codewords corresponds to the number of control bits added by the first encoder means (302) to selected positions of the codeword so that each control bit belongs to a corresponding sub-codeword, the value of said control bit thereby indicating if the sub-codeword is an inverted sub-codeword.

13. The system of Claim 1 wherein said error correction code is a palindromic (A,B) code in which the inversion of every $C^{th}$ symbol in any codeword of said code produces another codeword of said code, wherein C = a common divisor of A and B, wherein said codeword portions comprises every $C^{th}$ symbol of said codeword, there being C such portions.

14. The system of Claim 1 wherein w = (m+z)/2, whereby the numbers of zero and one bits in a given symbol are equal.

15. The system of Claim 2 wherein said row clock generator means (806) is characterized in that each of said successive analog values is first normalized by subtracting from it the average analog value for the entire row.

16. The system of Claim 2 suitable for recovering data bits of discrete bit values recorded on an optical recording medium (102) as longitudinal columns (108) and transversal rows (106) of optically detectable bit images (104) of different image densities associated with said discrete bit values, said row clock generator comprising:
   a) a periodic clock means (806) for enabling an optical sensor means (200) for sensing image densities of a current row (106) of said bit images (104) in accordance with a clock;
   b) a lead/lag means (822, 824, 826, 828) for sensing whenever an enabling of said optical sensor means (200) leads or lags, respectively, a longitudinal position centered on a bit image in said current row;
   c) a declaring means (826) for declaring a lead condition or a lag condition for the corresponding bit image in said current row in response to said lead/lag means; and

EP 0 494 267 B1

d) a polling means (830) for increasing or decreasing said clock period by a predetermined amount depending upon which one of said lead and lag conditions said means (826) for declaring declares for a majority of the bit images in said current row.

17. The system according to Claim 16, wherein:
said lead/lag means comprise means (828) for determining an algebraic difference between
(i) a difference C between an image density of a bit image in a current row and the average image density of all bit images in the current row, and
(ii) a difference P between an image density of the bit image in the same location in the previous row and the average image density of all bit images in the previous row.

18. The system according to claim 17, wherein:
whenever C and P are of the same algebraic sign, said lead/lag means determines a lag condition if the magnitude of C is greater than that of P and determines a lead condition otherwise, and whenever C and P are of different algebraic signs, said lead/lag means determines a lead condition if the magnitude of C is greater than of P and determines a lag condition otherwise.

19. The system of Claim 3 wherein centers of adjacent ones of said bit images within a row have a periodic spacing W, the bit value of the bit produced by said data desmearer for the $n^{th}$ one of said bit images in said current row is $d_n$, and wherein said means for correcting comprise:
means for changing $\psi$ so as to minimize a sum of the products of $(d_n-d_{n-1})$ of the bit images in the current row multiplied by an odd periodic function of $\psi$ while maximizing a sum of the products of $(d_n-d_{n-1})$ of the bit images in the current row multiplied by an even periodic function of $\psi$.

20. The system according to Claim 19, wherein said odd and even periodic functions comprise $\sin(2\pi\psi)$ and $\cos(2\pi\psi)$, respectively.

21. A method for processing a stream of digital data with respect to a data channel, said stream of digital data being encoded into successive codewords each comprising n m-bit symbols belonging to an error correction code, said successive codewords being recorded in a physical format (100) on a recording medium (102), the format consisting of rows (106) transverse to the recording direction and columns (108) extending in the recording direction, said method comprising the steps of:
(1) encoding said stream of digital data into said successive codewords each comprising n m-bit symbols belonging to said error correcting code, and adding synchronization symbols and control bits to selected positions of the codewords;
(2) encoding each of said m-bit symbols so as to produce m+z -bit symbols in accordance with a channel code wherein each of said m+z -bit symbols are of weight w;
(3) dividing said successive codewords into successive row groups of M bits so that each of said successive row groups comprising at least some of the symbols of said successive codewords and said row groups having commonly aligned bit positions;
(4) separating said codewords into a selected number of sub-codewords of equal length and producing related codewords by selectively inverting ones of said sub-codewords so as to maximize the number of bit positions in each of said row groups which contain bits different from those in alternate ones of said row groups, thereby marking said selected inversions by said control bits, said related codewords still being codewords for which said error correction code is valid.

22. The method according to Claim 21, wherein
said error correction code is of the type wherein the bits of each set comprising every $C^{th}$ code symbol of said codeword are inverted to form another codeword of said code; and
said step for producing said row groups of codewords comprises the step of inverting the bits of different combinations of the sets comprising every $C^{th}$ symbol of said codeword so as to produce different ones of said related codewords.

23. The method according to Claim 22, further comprising the step of selecting a related codeword of said row group, said selecting step comprising the step of:
determining which of said combinations produces the largest number of bit images in said current row having image densities different from the image densities of bit images in corresponding locations in a previous one of said rows.

14

24. The method according to Claim 23, wherein said encoding step comprises the step of reserving in said codeword a control bit for each set comprising every $C^{th}$ code symbol of said word, and wherein said step for producing said row group of codewords further comprises the step of setting to a predetermined value the control bit of each set of symbols inverted during said step for inverting in each of said related codewords.

25. The system according to Claims 1 or 21, wherein said error correction code comprises a Reed/Solomon code comprising a palindromic generator polynomial.

26. The system of Claims 1 or 2, wherein said signal transmitting means (312) comprises a linear array of light emitting elements arranged in the direction of said rows (106) transverse to the recording direction, the linear array having M light emitting elements corresponding to the M bits of said successive row groups, for exposing a strip of film (102) according to the processed data; and
said signal acquisition means (200) comprising a linear array of photodetectors (202) that are constructed and located with the array direction parallel to the row direction on the recording medium moving therepast, and extending over the boundaries of said recording track (100), said linear array consisting of M+N photodetectors (202) where M is the number of bit positions in said rows (106) and N is at least the number of photodetectors exceeding the width of said recording track (100).

## Patentansprüche

1. System zum Bearbeiten eines digitalen Datenstroms bezüglich eines Datenkanals, wobei der digitale Datenstrom in aufeinanderfolgende Kodewörter kodiert wird, von denen jedes n m-Bit-Symbole aufweist, die zu einem Fehlerkorrekturkode gehören, und wobei die aufeinanderfolgenden Kodewörter auf einem Aufzeichnungsträger (102) als Flächenmusteranordnung (100) aufgezeichnet werden, das aus quer zur Aufzeichnungsrichtung verlaufenden Reihen (106) und in Aufzeichnungsrichtung verlaufenden Spalten besteht, gekennzeichnet durch
   - erste Kodiermittel (302) zum Kodieren des digitalen Datenstroms in aufeinanderfolgende Kodewörter, von denen jedes n m-Bit-Symbole aufweist, die zu dem Fehlerkorrekturkode gehören, und zum Zufügen von Synchronisationssymbolen und Steuerbits an ausgewählte Stellen des Kodeworts;
   - zweite Kodiermittel (304) zum Kodieren jedes der m-Bit-Symbole, um m+z-Bit-Symbole entsprechend einem Kanalkode zu erzeugen, dessen jedes der m+z-Bit-Symbole die Gewichtung w aufweist;
   - Invertermittel (306, 308) zum Aufteilen der aufeinanderfolgenden Kodewörter in aufeinanderfolgende Reihengruppen von m Bits, wobei jede der Reihengruppen mindestens einige der Symbole der aufeinanderfolgenden Kodewörter aufweist und wobei die Reihengruppen gegenseitig ausgerichtete Bit-Stellen besitzen, und zum Aufteilen der Kodewörter in eine festgelegte Anzahl von Kodewortabschnitten gleicher Länge und zur Erzeugung von Bezugs-Kodewörtern durch wahlweises Invertieren von Kodewortabschnitten, um eine möglichst hohe Anzahl von Bit-Stellen in jeder der Reihengruppen zu erhalten, in denen Bits enthalten sind, welche sich von den in jeder zweiten Reihengruppe enthaltenen unterscheiden, wobei die ausgewählten Invertierungen durch die Steuerbits markiert werden und die Bezugs-Kodewörter noch immer solche sind, für die der Fehlerkorrekturkode Gültigkeit hat; und
   - Mittel (312) zum Übertragen von Analogsignalen an einen entsprechend der durch die Invertiermittel (306, 308) verarbeiteten Kodewörter kanalkodierten Symbole bezeichneten Kanal, wobei die Analogsignale Analogwerte umfassen, die in aufeinanderfolgende Reihen (106) von m Analogwertplätzen (104) geordnet sind, welche den m-Bits der aufeinanderfolgenden Reihengruppen entsprechen.

2. System nach Anspruch 1, gekennzeichnet durch
   - Analogsignal-Erfassungsmittel (200) mit m+n-Sensoren (202) zum Abtasten der Analogwerte an jeder der m Plätze (104) der aufeinanderfolgenden Reihen (106);
   - Reihen-Takterzeugungsmittel (806) zum Synchronisieren der Analogsignal-Erfassungsmittel (200) mit jeder der aufeinanderfolgenden Reihengruppen entsprechend einer Vektorsumme für jede der Reihen (106) von Differenzen zwischen den von den einzelnen Sensoren (202) abgetasteten Paaren aufeinanderfolgender Analogwerte;
   - Datenrekonstruktionsmittel (808)
      - zum Auswählen von mindestens m Sensoren aus den m+n-Sensoren (202), die einer räumlichen Übereinstimmung mit den m Plätzen (104) für jede der aufeinanderfolgenden Reihen (106) am nächsten liegen, und
- zum Übertragen

    eines Datenbits, der von der Nähe der von den einzelnen m Sensoren abgetasteten Analogwerte zu einem von zwei vorgegebenen, den Binärwerten von 1 bzw. 0 entsprechenden Analogwerten abhängig ist;
- eines Löschbits für jedes der Datenbits, für das der abgetastete Analogwert außerhalb einer vorgegebenen Schwellenwertgrenze bezüglich eines der beiden vorgegebenen Analogwerte liegt;
- Symbolgrenzen-Steuermittel (890, 900) zum Auswählen etwa jedes (m+z)-ten der Datenbits als erste Bits aufeinanderfolgender m+z-Bit-Symbole, um eine möglichst hohe Anzahl von eine Gewichtung w aufweisender m+z-Bit-Symbole zu erreichen, und zum Erzeugen der entsprechenden m+z-Bit-Symbole;
- Kanaldekodier- und Fehlerkorrekturmittel der ersten Stufe (808) mit
    - Mitteln (918) zum Invertieren derjenigen Daten-bits, die immer dann entsprechende von den Rekonstruktionsmitteln erzeugte Löschbits aufweisen, wenn das entsprechende, von den Rekonstruktionsmitteln erzeugte m+z-Bit-Symbol nicht die Gewichtung w hat, um ein verändertes Symbol zu erzeugen;
    - Mittel (926) zum Übermitteln einer Symbollöschungskennung, wenn das veränderte Symbol nicht die Gewichtung w hat; und
    - Mitteln (812) zur Kanaldekodierung entweder (a) des von den Rekonstruktionsmitteln erzeugten Symbols oder (b) des veränderten Symbols, um ein entsprechendes m-Bit-Symbol zu erzeugen; und
- Fehlerkorrekturmittel (816) zum Erfassen von n der von den Kanaldekodiermitteln (812) erzeugten 6-Bit-Symbole und Dekodieren des Kodeworts.

3. System nach Anspruch 2, dadurch gekennzeichnet, daß die Datenrekonstruktionsmittel (808) zum Auswählen von m Sensoren folgende Komponenten aufweisen:
- Phasenwort-Erzeugungsmittel (810) zum Errechnen der Teilsummen des Produkts aus (a) der Differenz zwischen den an einem Platz (104) und dem ihm in der Reihe unmittelbar vorausgehenden Platz enthaltenen Analogwerten und (b) einer Quasi-Tangensfunktion eines Winkels $\psi$, der die Lage der Plätze (104) bezüglich der Sensoren (202) in numerischen Einheiten darstellt, in denen der Abstand zwischen den Sensoren gleich 1 ist; und
- Korrekturmittel (810a) zum Errechnen der Lage des Mittelpunkts eines jeden Platzes (104) einer Reihe bezüglich der Sensoren (202).

4. System nach Anspruch 3, dadurch gekennzeichnet, daß die Korrekturmittel folgende Komponenten umfassen:
- Mittel (810a), die eine Veränderung des Winkels $\psi$ zwischen benachbarten Sensoren (202) aus den Teilsummen errechnen.
- Mittel (808), die die Lage des ersten Sensors (202) bezüglich des ersten der Plätze (104) aus den Teilsummen errechnen;
- Mittel (808), die $\psi$ um $K\pi\psi$ erhöhen, wobei k etwa der Anzahl der Sensoren pro Platz entspricht.

5. System nach Anspruch 2, dadurch gekennzeichnet, daß die Datenrekonstruktionsmittel (808) zum Übermitteln des Datenbits Mittel zum Gewichten der Analogwerte von Paaren von den Mittelpunkt von Plätzen überspannenden Sensoren aufweisen, wobei die Gewichtung proportional zu deren Entfernung von den jeweiligen Mittelpunkten erfolgt.

6. System nach Anspruch 2, dadurch gekennzeichnet, daß die Symbolgrenzen-Steuermittel (890, 900) Mittel (898) aufweisen, die für jede der m+z möglichen Bitstellen einen Stellenwert für das erste Bit jedes Symbols aufrechterhalten, den Stellenwert erhöhen, wenn das entsprechende m+z-Bit-Symbol die Gewichtung w aufweist oder erniedrigen, wenn das entsprechende m+z-Bit-Symbol die Gewichtung w nicht aufweist, und stets dann eine Vorteil-Bitstelle bezeichnen, wenn deren Stellenwert wenigstens annähernd einer vorgegebenen Mindestpunktzahl entspricht.

7. System nach Anspruch 6, dadurch gekennzeichnet, daß der vorgegebene Mindeststellenwert wenigstens annähernd $2^{m+z-1}-1$ ist.

8. System nach Anspruch 6, dadurch gekennzeichnet, daß die Mittel (898) zur Aufrechterhaltung des Stellenwerts diesen je nachden um 1 erniedrigen oder um 2 erhöhen.

9. System nach Anspruch 2, dadurch gekennzeichnet, daß die Fehlerkorrekturmittel (816) folgende Mittel umfassen:
   - Fehlererkennungsmittel, die in jedem mit einer Löschungskennung versehenen Symbol ein Ausbleiben von Fehlern erkennen;
   - Mittel zum Übertragen von Kodewort-Stummschaltungskennungen, die entscheiden, ob die Anzahl der Löschungskennungen für ein bestimmtes Kodewort abzüglich der Anzahl von Löschungskennungen, für die die Fehlererkennungsmittel keinen Fehler gefunden haben, eine Mindestanzahl h abzüglich der Anzahl der Redundanzcheck-Symbole des Kodeworts übersteigt.

10. System nach Anspruch 9, dadurch gekennzeichnet, daß die Fehlererkennungsmittel die Anzahl der Fehler an irgendeiner Stelle des Kodeworts erkennen, und daß die Stummschaltungskennungs-Übertragungsmittel der Anzahl von Löschungen die Anzahl der von den Fehlererkennungsmitteln erkannten Fehler hinzuaddieren.

11. System nach Anspruch 2, dadurch gekennzeichnet, daß
   - die Mittel zum Übertragen von Analogsignalen Mittel (312) zum fotografischen Erzeugen von lichtundurchlässigen (104b) und lichtdurchlässigen (104a) Stellen auf einem Filmstreifen (102) aufweisen, wobei die Reihengruppen horizontale Reihen (106) von Stellen (104) auf dem Film (102) enthalten; und
   - die Mittel zum Erfassen des Analogsignals eine zeilenförmige Anordnung (200) von den m+n-Sensoren (202) entsprechenden Bildsensoren aufweisen, die im wesentlichen in Richtung der horizontalen Reihen (106) ausgerichtet ist.

12. System nach Anspruch 1, dadurch gekennzeichnet, daß die Anzahl der Kodewortabschnitte der Anzahl von Steuerbits, die von den ersten Kodiermitteln (302) ausgewählten Stellen des Kodeworts hinzugefügt wurden, entspricht, so daß jedes Steuerbit einem bestimmten Kodewortabschnitt zugeordnet ist, wobei der Wert des Steuerbits anzeigt, ob der Kodewortabschnitt ein invertierter Kodewortabschnitt ist.

13. System nach Anspruch 1, dadurch gekennzeichnet, daß der Fehlerkorrekturkode ein Palindrom (A,B)-Kode ist, bei dem die Invertierung jedes c-ten Symbols in einem Kodewort des Kodes ein weiteres Kodewort des Kodes erzeugt, wobei c ein gemeinsamer Teiler von A und B ist, und wobei die Kodewortabschnitte jedes c-te Symbol des Kodeworts umfassen, und insgesamt c solcher Abschnitte vorhanden sind.

14. System nach Anspruch 1, dadurch gekennzeichnet, daß w=(m+z)/2, wobei die Anzahl von jeweils Null- und Eins-Bits in einem bestimmten Symbol gleich ist.

15. System nach Anspruch 2, dadurch gekennzeichnet, daß in den Reihen-Takterzeugungsmitteln (806) jeder der aufeinanderfolgenden Analogwerte zunächst normiert wird, indem von ihm der durchschnittliche Analogwert für die gesamte Reihe subtrahiert wird.

16. System nach Anspruch 2, geeignet zur Wiedergewinnung von Datenbits aus diskreten, in Form von Spalten (108) und Reihen (106) auf einem optischen Aufzeichnungsmedium (102) und als optisch erfaßbare Bit-Stellen (104) unterschiedlicher optischer Dichte aufgezeichneten Bitwerten, die den diskreten Bitwerten zugeordnet sind, wobei die Reihen-Takterzeugungsmittel durch folgende Komponenten <u>gekennzeichnet</u> sind:
   a) einen Taktfrequenzgenerator (806), der einen optischen Sensor (200) aktiviert, um die Bilddichten einer aktuellen Reihe (106) von Bit-Stellen (104) taktweise zu ermitteln;
   b) eine Voreil-/Nacheil-Ermittlungseinrichtung (822, 824, 826, 828) zur Feststellung, ob die Aktivierung des optischen Sensors (200) der auf eine Bitstelle in der aktuellen Reihe zentrierte Längenposition vor- bzw. nacheilt;
   c) Bezeichnungsmittel (826) zum Bezeichnen eines Vor- oder Nacheilzustands der entsprechenden Bitstelle in der aktuellen Reihe in Abhängigkeit von der Voreil-/Nacheil-Ermittlungseinrichtung; und
   d) Entscheidungsmittel (830) zum Erhöhen oder Verringern der Taktfrequenz um einen vorgegebenen Betrag, je nachdem, ob ein von dem Bezeichnungsmittel als Vor- bzw. Nacheilzustand für die Mehrzahl der Bitstellen in der aktuellen Reihe bezeichneter Zustand vorliegt.

17. System nach Anspruch 16, dadurch gekennzeichnet, daß die Voreil-/Nacheil-Ermittlungseinrichtung Mittel (828) aufweist zum Bestimmen einer algebraischen Differenz zwischen

i) einer Differenz c zwischen der optischen Dichte einer Bitstelle in einer aktuellen Reihe und der durchschnittlichen optischen Dichte aller Bitstellen der aktuellen Reihe, und

ii) einer Differenz p zwischen der optischen Dichte der Bitstelle an der gleichen Stelle der vorhergehenden Reihe und der durchschnittlichen optischen Dichte aller Bitstellen jener Reihe.

18. System nach Anspruch 17, dadurch gekennzeichnet, daß bei gleichen Vorzeichen von c und p die Voreil-/ Nacheil-Ermittlungseinrichtung einen Nacheilzustand bezeichnet, wenn die Größe von c diejenige von p übersteigt, und im umgekehrten Fall einen Voreilzustand bezeichnet, und daß sie bei unterschiedlichen Vorzeichen von c und p einen Voreilzustand bezeichnet, wenn die Größe von c diejenige von p übersteigt, und im umgekehrten Fall einen Nacheilzustand bezeichnet.

19. System nach Anspruch 3, dadurch gekennzeichnet, daß die Mittelpunkte benachbarter Bitstellen einer Reihe einen periodischen Abstand W voneinander aufweisen, daß der Bitwert des von der Datenrekonstruktionseinrichtung für die n-te Bitstelle in der aktuellen Reihe erzeugte Bit $d_n$ ist, und daß die Korrekturmittel Mittel aufweisen, die $\psi$ so verändern, daß die Summe der Produkte aus $(d_n-d_{n-1})$ der Bitstellen in der aktuellen Reihe und einer ungeradzahligen periodischen Funktion von $\psi$ auf ein Minimum reduziert, wohingegen die Summe der Produkte aus $(d_n-d_{n-1})$ der Bitstellen in der aktuellen Reihe und einer geradzahligen periodischen Funktion von $\psi$ maximiert werden.

20. System nach Anspruch 19, dadurch gekennzeichnet, daß die ungeradzahligen und geradzahligen periodischen Funktionen sin $(2\pi\psi)$ und cos $(2\pi\psi)$ umfassen.

21. Verfahren zum Verarbeiten eines digitalen Datenstroms bezüglich eines Datenkanals, wobei der digitale Datenstrom in aufeinanderfolgende Kodewörter kodiert wird, von denen jedes n m-Bit-Symbole aufweist, die zu einem Fehlerkorrekturkode gehören, und wobei die aufeinanderfolgenden Kodewörter auf einem Aufzeichnungsträger (102) als Flächenmuster (100), das aus quer zur Aufzeichnungsrichtung verlaufenden Reihen (106) und in Aufzeichnungsrichtung verlaufenden Spalten besteht, aufgezeichnet sind, gekennzeichnet durch folgende Schritte:

1) Kodieren des digitalen Datenstroms in aufeinanderfolgende Kodewörter, von denen jedes n m-Bit-Symbole aufweist, die zu dem Fehlerkorrekturkode gehören, und zum Hinzufügen von Synchronisationssymbolen und Steuerbits an ausgewählte Stellen des Kodeworts;

2) Kodieren jedes der m-Bit-Symbole, um m+z-Bit-Symbole entsprechend einem Kanalkode zu erzeugen, dessen jedes der m+z-Bit-Symbole die Gewichtung w aufweist;

3) Aufteilen der aufeinanderfolgenden Kodewörter in aufeinanderfolgende Reihengruppen von m Bits, wobei jede der Reihengruppen mindestens einige der Symbole der aufeinanderfolgenden Kodewörter aufweist und wobei die Reihengruppen gegenseitig ausgerichtete Bit-Stellen besitzen,

4) Aufteilen der Kodewörter in eine festgelegte Anzahl von Kodewortabschnitten gleicher Länge und Erzeugen von Bezugs-Kodewörtern durch Invertieren bestimmter Kodewortabschnitte, um eine möglichst hohe Anzahl von Bit-Stellen in jeder der Reihengruppen zu erhalten, in denen sich von den in jeder zweiten Reihengruppe enthaltenen Bits unterscheidende Bits enthalten sind, wobei die Invertierungen durch die Steuerbits markiert werden und die Bezugs-Kodewörter noch immer solche sind, für die der Fehlerkorrekturkode Gültigkeit hat.

22. Verfahren nach Anspruch 21, dadurch gekennzeichnet,

- daß der Fehlerkorrekturkode derart ausgelegt ist, daß die Bits derjenigen Sätze, der jedes c-te Kodesymbol des Kodeworts umfassen, invertiert werden, um ein weiteres Kodewort des Kodes zu bilden; und

- daß der Schritt zum Erzeugen der Reihengruppen von Kodewörtern einen Schritt umfaßt, in dem die Bits unterschiedlicher Satz-Kombinationen, die jedes c-te Symbol des Kodeworts umfassen, invertiert werden, so daß unterschiedliche Bezugs-Kodewörter erzeugt werden.

23. Verfahren nach Anspruch 22, gekennzeichnet durch das Auswählen eines Bezugs-Kodeworts der Reihengruppe, wobei dieser Schritt den folgenden weiteren Schritt umfaßt:

- Feststellen, welche der Kombinationen die größere Anzahl Bitstellen in der aktuellen Reihe erzeugt, deren optische Dichten sich von denen der an gleicher Stelle in einer der vorhergehenden Reihen stehenden Bitstellen unterscheiden.

24. Verfahren nach Anspruch 23, dadurch gekennzeichnet, daß der Kodierschritt die Reservierung eines Steuerbits in dem Kodewort für diejenigen Sätze umfaßt, die jedes c-te Kodesymbol des Wortes aufweisen, und daß der Schritt zum Erzeugen der Reihengruppen von Kodewörtern den weiteren Schritt umfaßt, in dem das Steuer-Bit derjenigen Symbolsätze, die in dem Invertierungsschritt jedes der Bezugs-Kodewörter invertiert wurden, auf einen vorgegebenen Wert festgelegt wird.

25. Verfahren nach Anspruch 1 oder 2, dadurch gekennzeichnet, daß der Fehlerkorrekturkode einen Reed-Solomon-Kode umfaßt, der ein Palindromerzeugungs-Polynom aufweist.

26. System nach Anspruch 1 oder 2, dadurch gekennzeichnet,
   - daß die Signalübertragungsmittel (312) eine zeilenförmige, sich in Richtung der Reihen (106) und quer zur Aufzeichnungsrichtung erstreckende Anordnung aus m lichtemittierenden Elementen aufweisen, die in Übereinstimmung mit den m Bits der aufeinanderfolgenden Reihengruppen zum Belichten eines Filmstreifens (102) entsprechend den verarbeiteten Daten vorgesehen sind; und
   - daß die Signalerfassungsmittel (200) eine zeilenförmige Anordnung von Fotodetektoren (202) aufweisen, die so gestaltet und innerhalb der Anordnung derart positioniert sind, daß sie sich parallel zu den auf den an ihnen vorbeibewegten Aufzeichnungsmedium befindlichen Reihen erstrecken, und dabei über die seitlichen Begrenzungen der Aufzeichnungsspur (100) hinausreichen, wobei die Anordnung aus m+n Fotodetektoren (202) besteht und wobei m die Anzahl der in den Reihen (106) vorhandenen Bit-Stellen und n mindestens die Anzahl der über die Breite der Aufzeichnungsspur (100) hinausreichenden Fotodetektoren darstellen.

**Revendications**

1. Système pour traiter un train de données numériques se rapportant à un canal de données, ledit train de données numériques étant codé en mots de code successifs comprenant chacun n symboles à m bits appartenant à un code de correction d'erreur, lesdits mots de code successifs étant enregistrés en un format physique (100) sur un support d'enregistrement (102), le format étant constitué de rangées (106) transversales à la direction de l'enregistrement et de colonnes (108) s'étendant dans la direction d'enregistrement, ledit système étant
caractérisé par :
   un premier moyen de codeur (302) pour coder ledit train de données numériques en lesdits mots de code successifs comprenant chacun n symboles à m bits appartenant audit code de correction d'erreur et pour ajouter des symboles de synchronisation et des bits de commande à des positions choisies du mot de code,
   un second moyen de codeur (304) pour coder chacun desdits symboles à m bits de façon à produire des symboles à m + z bits en conformité avec un code de canal, ledit code de canal étant caractérisé en ce que chacun desdits symboles à m + z bits sont d'un poids w,
   un moyen d'inversion (306, 308) pour partager lesdits mots de code successifs en groupes de rangées successifs de M bits, chaque groupe desdits groupes de rangées successifs comprenant au moins certains des symboles desdits mots de code successifs, lesdits groupes de rangées ayant des positions de bits alignées ensemble,
   et pour séparer lesdits mots de code en un nombre choisi de sous-mots de code de longueur égale et produire les mots de code apparentés en inversant sélectivement certains desdits sous-mots de code de façon à maximiser le nombre de positions de bits dans chacun desdits groupes de rangées qui contiennent des bits différents dans des groupes alternés desdits groupes de rangées, d'où il résulte que lesdites inversions sélectionnées sont repérées par lesdits bits de commande et lesdits mots de code apparentés restent toujours des mots de code pour lesquels ledit code de correction d'erreur est valide, et
   un moyen (312) pour transmettre des signaux analogiques audit canal représentant les symboles codés de canal correspondant aux mots de code traités par ledit moyen d'inversion (306, 308), dans lequel lesdits signaux analogiques comportent des valeurs analogiques organisées en rangées successives (106) de M sites de valeur analogique (104) correspondant aux M bits desdits groupes de rangées successifs.

2. Système selon la revendication 1, comprenant de plus :
   un moyen d'acquisition de signal analogique (200) comprenant M + N capteurs (202) destinés à détecter les valeurs analogiques à chacun desdits M sites (104) de chaque rangée desdites rangées successives (106),

un moyen de générateur d'horloge de rangée (806) pour synchroniser ledit moyen d'acquisition de signal analogique (200) avec chacun desdits groupes de rangées de successifs en conformité avec une somme vectorielle, pour chacune desdites rangées (106), des différences entre les paires de valeurs analogiques successives détectées aux capteurs individuels desdits capteurs (202),

un moyen de remise en forme de données (808) pour :

sélectionner à partir desdits M + N capteurs (202) au moins M capteurs qui sont les mieux alignés avec lesdits M sites (104) pour chaque rangée parmi lesdites rangées successives (106) et

transmettre :

un bit de données basé sur la proximité de la valeur analogique détectée par chacun desdits M capteurs sélectionnés, d'une de deux valeurs analogiques prédéterminées correspondant à des valeurs binaires de un et zéro, respectivement, et

un bit d'effacement pour chacun desdits bits de données pour lequel la valeur analogique détectée est au-delà d'une distance de seuil prédéterminée de l'une desdites valeurs analogiques prédéterminées,

un moyen de commande de limite de symbole (890, 900) pour choisir, environ chaque $(m+z)^{ème}$ bit, un bit parmi les bits de données en tant que premiers bits des symboles successifs à m+z bits de façon à maximiser le nombre desdits symboles à m+z bits ayant le poids w et pour produire les symboles à m+z bits correspondants,

un moyen de décodage de canal et de correction d'erreur de premier niveau (808), comprenant :

un moyen (918) pour inverser ceux des bits de données ayant des bits d'effacement correspondants provenant dudit moyen de remise en forme de données, chaque fois que le symbole à m+z bits correspondant produit par ledit moyen de remise en forme de données n'est pas d'un poids w ce qui produit un symbole altéré, et

un moyen (926) pour transmettre un indicateur d'effacement de symbole, chaque fois que ledit symbole altéré n'est pas d'un poids w, et

un moyen (812) pour un décodage de canal soit (a) dudit symbole produit par ledit moyen de remise en forme de données, soit (b) dudit symbole altéré afin de produire un symbole à m bits correspondant, et

un moyen de correction d'erreur (816) pour acquérir n symboles parmi les symboles à   six   bits produits par ledit moyen de décodage de canal (812) et décoder ledit mot de code.

3. Système selon la revendication 2, dans lequel ledit moyen de remise en forme de données (808) pour sélectionner M capteurs, comprend :

un moyen de générateur de mot de phase (810) pour calculer les sommes partielles du produit de (a) la différence entre les valeurs analogiques d'un site (104) et de son prédécesseur dans la rangée et (b) d'une fonction analogue à une tangente d'un angle $\psi$ représentant la position desdits sites (104) par rapport auxdits capteurs (202) en unités numériques, dans lequel le pas entre lesdits capteurs est égal à un, et

un moyen de correction (810a) pour calculer l'emplacement par rapport auxdits capteur (202) des centres de chacun des sites (104) dans une rangée.

4. Système selon la revendication 3, dans lequel ledit moyen de correction comprend :

un moyen (810a) pour calculer à partir desdites sommes partielles la variation dudit angle $\psi$ entre des capteurs adjacents parmi lesdits capteurs (202),

un moyen (808) pour calculer à partir desdites sommes partielles la position du premier capteur parmi lesdits capteurs (202) par rapport au premier site parmi lesdits sites (104),

un moyen (808) pour incrémenter $\psi$ de $K\pi\psi$ où K correspond approximativement au nombre de capteurs pour chaque site.

5. Système selon la revendication 2, dans lequel ledit moyen de remise en forme de données (808) destiné à transmettre ledit bit de données comprend un moyen pour pondérer les valeurs analogiques des paires desdits capteurs englobant le centre des sites respectifs parmi lesdits sites, proportionnellement à leur proximité dudit centre.

6. Système selon la revendication 2, dans lequel ledit moyen de commande de limite de symbole (890, 900) comprend un moyen (898) pour conserver une évaluation, pour chacune des m+z positions possibles, du premier bit de chaque symbole et pour incrémenter ladite évaluation chaque fois que le symbole à m+z bits correspondant a un poids w et pour décrémenter ladite évaluation chaque fois que le symbole à m+z bits correspondant n'a pas le poids w et pour déclarer une position de bit gagnant, chaque fois que l'évaluation correspondante est au moins presqu'une évaluation de seuil prédéterminée.

7. Système selon la revendication 6, dans lequel ladite évaluation de seuil prédéterminée est au moins presque $2^{m+z-1}-1$.

8. Système selon la revendication 6, dans lequel ledit moyen (898) pour conserver une évaluation, décrémente ladite évaluation de un et incrémente ladite évaluation de deux.

9. Système selon la revendication 2, dans lequel ledit moyen de correction d'erreur (816) comprend :

un moyen de détection d'erreur pour détecter une absence de toute erreur quelconque dans chaque symbole associé à un indicateur d'effacement,

un moyen de transmission d'indicateur de neutralisation de mot de code pour déterminer si le nombre des indicateurs d'effacement pour un mot de code donné moins le nombre des indicateurs d'effacement pour lesquels aucune erreur n'a été trouvée par ledit moyen de détection d'erreur, dépasse une valeur de seuil h inférieure au nombre de symboles de contrôle redondants dans ledit mot de code.

10. Système selon la revendication 9, dans lequel ledit moyen de détection d'erreur détecte de plus le nombre d'erreurs de chaque emplacement quelconque dans ledit mot de code et dans lequel ledit moyen de transmission d'indicateur de neutralisation ajoute au nombre d'effacements le nombre des erreurs détectées par ledit moyen de détection d'erreur.

11. Système selon la revendication 2, dans lequel :

ledit moyen pour transmettre des signaux analogiques comprend un moyen (312) pour enregistrer photographiquement des sites opaques (104b) et transparents (104a) sur une bande d'un film (102) dans lequel lesdits groupes de rangées comprennent des rangées horizontales (106) desdits sites (104) sur ledit film (102), et

ledit moyen pour acquérir ledit signal analogique comprend un réseau linéaire (200) de capteurs image correspondant auxdits M+N capteurs (202), ledit réseau étant généralement aligné dans la direction desdites rangées horizontales (106).

12. Système selon la revendication 1, dans lequel le nombre desdits sous-mots de code correspond au nombre de bits de commande ajoutés par le premier moyen de codeur (302) aux positions choisies du mot de code, de sorte que chaque bit de commande appartient à un sous-mot de code correspondant, la valeur dudit bit de commande indiquant de ce fait si le sous-mot de code est un sous-mot de code inversé.

13. Système selon la revendication 1, dans lequel ledit code de correction d'erreur est un code palindromique (A, B) dans lequel l'inversion de chaque $C^{\text{ème}}$ symbole dans tout mot de code dudit code produit un autre mot de code dudit code, dans lequel C est un diviseur commun de A et B, dans lequel lesdites parties de mot de code comprennent chaque Cème symbole dudit mot de code, et où il existe C parties.

14. Système selon la revendication 1, dans lequel w = (m+z)/2, d'où il résulte que le nombre des bits à zéro et à un dans un symbole donné sont égaux.

15. Système selon la revendication 2, dans lequel ledit moyen de générateur d'horloge de rangée (806) est caractérisé en ce que chacune desdites valeurs analogiques successives est tout d'abord normalisée en soustrayant de celle-ci la valeur analogique moyenne pour la rangée entière.

16. Système selon la revendication 2, approprié pour la reconstitution de bits de données de valeurs de bit discrètes enregistré sur un support d'enregistrement optique (102) en tant que colonnes longitudinales (108) et rangées transversales (106) d'images de bit optiquement détectable (104) de densités d'image différentes associées auxdites valeurs de bit discrètes, ledit générateur d'horloge de rangée comprenant :

a) un moyen d'horloge périodique (806) pour activer un moyen de capteur optique (200) pour détecter les densités d'image d'une rangée actuelle (106) desdites images de bit (104) en conformité avec une horloge,

b) un moyen d'avance/retard (822, 824, 826, 828) pour détecter si une validation dudit moyen de capteur optique (200) est en avant ou en arrière, respectivement, d'une position longitudinale centrée sur une image de bit dans ladite rangée actuelle,

c) un moyen de déclaration (826) pour déclarer une condition d'avance ou une condition de retard pour l'image de bit correspondante dans ladite rangée actuelle en réponse audit moyen d'avance/retard, et

d) un moyen d'interrogation (830) pour augmenter ou diminuer ladite période d'horloge d'une quantité prédéterminée suivant la condition parmi lesdites conditions d'avance et de retard que ledit moyen (826) pour déclarer déclare pour une majorité d'images de bit dans ladite rangée actuelle.

**17.** Système selon la revendication 16, dans lequel : ledit moyen d'avance/retard comprend un moyen (828) pour déterminer une différence algébrique entre,

(i) une différence C entre une densité d'image d'une image de bit dans une rangée actuelle et la densité d'image moyenne de la totalité des images de bits dans la rangée actuelle, et

(ii) une différence P entre une densité d'image de l'image de bit au même emplacement dans la rangée précédente et la densité d'image moyenne de la totalité des images de bits dans la rangée précédente.

**18.** Système selon la revendication 17, dans lequel :

chaque fois que C et P sont du même signe algébrique, ledit moyen d'avance/retard détermine une condition de retard si l'amplitude de C est supérieure à celle de P et sinon détermine une condition d'avance et chaque fois que C et P sont de signes algébriques différents, ledit moyen d'avance/retard détermine une condition d'avance si l'amplitude de C est supérieure à celle de P et détermine dans l'autre cas une condition de retard.

**19.** Système selon la revendication 3, dans lequel les centres des images adjacentes parmi lesdites images de bits à l'intérieur d'une rangée ont un espacement périodique W, la valeur de bit du bit produit par ledit dispositif de remise en forme de données pour la nème image parmi lesdites images de bits dans ladite rangée actuelle est $d_n$ et dans lequel ledit moyen de correction comprend :

un moyen pour faire varier $\psi$ de façon à minimiser la somme des produits de $(d_n-d_{n-1})$ des images de bits de la rangée actuelle multipliée par une fonction périodique impaire de $\psi$ tout en maximisant une somme des produits de $(d_n-d_{n-1})$ des images de bits dans la rangée actuelle multipliée par une fonction périodique paire de $\psi$.

**20.** Système selon la revendication 19, dans lequel lesdites fonctions périodiques impaire et paire comprennent $\sin(2Ò\psi)$ et $\cos(2Ò\psi)$, respectivement.

**21.** Procédé pour traiter un train de données numériques par rapport à un canal de données, ledit train de données numériques étant codé en mots de code successifs comprenant chacun n symboles à m bits appartenant à un code de correction d'erreur, lesdits mots de code successifs étant enregistrés en un format physique (100) sur un support d'enregistrement (102), le format étant constitué de rangées (106) transversales à la direction de l'enregistrement et de colonnes (108) s'étendant dans la direction de l'enregistrement, ledit procédé comprenant les étapes consistant à :

(1) coder ledit train de données numériques en lesdits mots de code successifs comprenant chacun n symboles à m bits appartenant audit code de correction d'erreur et ajouter des symboles de synchronisation et des bits de commande aux positions choisies des mots de code,

(2) coder chacun desdits symboles à m bits de façon à produire des symboles à m+z bits en conformité avec un code de canal, dans lequel chacun desdits symboles à m+z bits est d'un poids w,

(3) partager lesdits mots de code successifs en groupes de rangées successifs de M bits, de sorte que chacun desdits groupes de rangées successifs comprend au moins certains des symboles desdits mots de code successifs et lesdits groupes de rangées ont des positions de bit alignées ensemble,

(4) séparer lesdits mots de code en un nombre choisi de sous-mots de code de longueur égale et produire des mots de code apparentés en inversant sélectivement certains des sous-mots de code de façon à maximiser le nombre des positions de bits dans chacun desdits groupes de rangées qui contiennent des bits différents de ceux des groupes alternés desdits groupes de rangéess, repérant de ce fait lesdites inversions sélectionnées par lesdits bits de commande, lesdits mots de code apparentés restant toujours des mots de code pour lesquels le code de correction d'erreur est valide.

**22.** Procédé selon la revendication 21, dans lequel :

ledit code de correction d'erreur est du type dans lequel les bits de chaque ensemble comprenant chaque Cème symbole de code dudit mot de code sont inversés afin de former un autre mot de code dudit code, et

ladite étape pour produire lesdits groupes de rangées de mots de code comprend l'étape consistant à inverser les bits des différentes combinaisons des ensembles comprenant chaque Cème symbole dudit mot de code de façon à produire des mots de code différents parmi lesdits mots de code apparentés.

**23.** Procédé selon la revendication 22, comprenant de plus l'étape consistant à sélectionner un mot de code apparenté dudit groupe de rangées, ladite étape de sélection comprenant l'étape consistant à :

déterminer laquelle desdites combinaisons produit le plus grand nombre d'images de bit dans ladite rangée actuelle ayant des densités d'image différentes des densités d'image des images de bit dans les emplacements correspondants dans une rangée précédente parmi lesdites rangées.

**24.** Procédé selon la revendication 23, dans lequel ladite étape de codage comprend une étape consistant à réserver dans ledit mot de code un bit de commande pour chaque ensemble comprenant chaque $C^{ème}$ symbole de code dudit mot et dans lequel l'étape pour produire ledit groupe de rangées de mots de code comprend de plus l'étape consistant à attribuer une valeur prédéterminée au bit de commande de chaque ensemble de symboles inversés pendant ladite étape consistant à inverser chacun desdits mots de code apparentés.

**25.** Système selon la revendication 1 ou 21, dans lequel ledit code de correction d'erreur comprend un code Reed/Solomon comprenant un polynôme générateur palindromique.

**26.** Système selon la revendication 1 ou 2, dans lequel ledit moyen de transmission de signal (312) comprend un réseau linéaire d'éléments émettant de la lumière disposé dans la direction desdites rangées (106) transversales à la direction de l'enregistrement, le réseau linéaire comportant M éléments émettant la lumière correspondant aux M bits desdits groupes de rangées successifs, destiné à exposer une bande de film (102) conformément aux données traitées, et

ledit moyen d'acquisition de signal (200) comprend un réseau linéaire de détecteurs photo-électriques (202) qui sont construits et placés dans la direction du réseau parallèle à la direction des rangées sur le support d'enregistrement passant devant celle-ci, et s'étendant entre les limites de ladite piste d'enregistrement (100), ledit réseau linéaire étant constitué de M+N détecteurs photo-électriques (202), où M est le nombre de positions de bits dans lesdites rangées (106) et N est au moins le nombre de détecteurs photo-électriques dépassant la largeur de ladite piste d'enregistrement (100).

EP 0 494 267 B1

FIG. IA

0.100"

102

100

1000

FIG. IB

ROW-TO-ROW
TRANSITIONS

COLUMN-TO-COLUMN TRANSITIONS

106

108

104b

104a

FIG. 2

FIG. 3

EP 0 494 267 B1

RS ENCODER

GRAB NEXT INCOMING
285 BIT BLOCK

ADD THREE INVERSION
CONTROL BITS EACH = 0

ADD LEADING &
TRAILING SYNC SYMBOLS

DIVIDE BIT STREAM
INCLUDING LEADING SYNC
SYMBOL INTO 49 SIX-BIT
MESSAGE SYMBOLS

COMPUTE 14 6-BIT CHECK
SYMBOLS FROM THE
49 MESSAGE SYMBOLS

OUTPUT RS (63, 49)
CODEWORD

FIG. 4

27

| 6-CODE HEX | 6-CODE BINARY | 8-CODE HEX | 8-CODE BINARY | 6-CODE HEX | 6-CODE BINARY | 8-CODE HEX | 8-CODE BINARY |
|---|---|---|---|---|---|---|---|
| 00 | 000000 | 17 | 00010111 | 20 | 100000 | 8B | 10001011 |
| 01 | 000001 | 1B | 00011011 | 21 | 100001 | 8D | 10001101 |
| 02 | 000010 | 1D | 00011101 | 22 | 100010 | 8E | 10001110 |
| 03 | 000011 | 27 | 00100111 | 23 | 100011 | 93 | 10010011 |
| 04 | 000100 | 2B | 00101011 | 24 | 100100 | 95 | 10010101 |
| 05 | 000101 | 2D | 00101101 | 25 | 100101 | 96 | 10010110 |
| 06 | 000110 | 2E | 00101110 | 26 | 100110 | 99 | 10011001 |
| 07 | 000111 | 33 | 00110011 | 27 | 100111 | 9A | 10011010 |
| 08 | 001000 | 35 | 00110101 | 28 | 101000 | 9C | 10011100 |
| 09 | 001001 | 36 | 00110110 | 29 | 101001 | A3 | 10100011 |
| 0A | 001010 | 39 | 00111001 | 2A | 101010 | A5 | 10100101 |
| 0B | 001011 | 3A | 00111010 | 2B | 101011 | A6 | 10100110 |
| 0C | 001100 | 3C | 00111100 | 2C | 101100 | A9 | 10101001 |
| 0D | 001101 | 47 | 01000111 | 2D | 101101 | AA | 10101010 |
| 0E | 001110 | 4B | 01001011 | 2E | 101110 | AC | 10101100 |
| 0F | 001111 | 4D | 01001101 | 2F | 101111 | B1 | 10110001 |
| 10 | 010000 | 4E | 01001110 | 30 | 110000 | B2 | 10110010 |
| 11 | 010001 | 53 | 01010011 | 31 | 110001 | B4 | 10110100 |
| 12 | 010010 | 55 | 01010101 | 32 | 110010 | B8 | 10111000 |
| 13 | 010011 | 56 | 01010110 | 33 | 110011 | C3 | 11000011 |
| 14 | 010100 | 59 | 01011001 | 34 | 110100 | C5 | 11000101 |
| 15 | 010101 | 5A | 01011010 | 35 | 110101 | C6 | 11000110 |
| 16 | 010110 | 5C | 01011100 | 36 | 110110 | C9 | 11001001 |
| 17 | 010111 | 63 | 01100011 | 37 | 110111 | CA | 11001010 |
| 18 | 011000 | 65 | 01100101 | 38 | 111000 | CC | 11001100 |
| 19 | 011001 | 66 | 01100110 | 39 | 111001 | D1 | 11010001 |
| 1A | 011010 | 69 | 01101001 | 3A | 111010 | D2 | 11010010 |
| 1B | 011011 | 6A | 01101010 | 3B | 111011 | D4 | 11010100 |
| 1C | 011100 | 6C | 01101100 | 3C | 111100 | D8 | 11011000 |
| 1D | 011101 | 71 | 01110001 | 3D | 111101 | E2 | 11100010 |
| 1E | 011110 | 72 | 01110010 | 3E | 111110 | E4 | 11100100 |
| 1F | 011111 | 74 | 01110100 | 3F | 111111 | E8 | 11101000 |

## FIG. 5

FILM BYTE POSITION

```
0 0 0 0 0 0 0 0 0 1 1 1 1 1 1 1 1 1 1 2 2 2 2   (POSITION 23
1 2 3 4 5 6 7 8 9 0 1 2 3 4 5 6 7 8 9 0 1 2 3    IS ONLY 4 BITS)
```

|———————➤ MESSAGE

ROW N

```
S B C A B C A B C A B C A B C A B C A B C A B
0 0 0 0 0 0 0 0 0 0 0 0 0 0 0 0 0 0 0 0 0 0 0
1 0 0 1 1 1 2 2 2 3 3 3 4 4 4 5 5 5 6 6 6 7 7
```
|———————➤ CURRENT BLOCK

ROW, N+1

```
B C A B C A B C A B C A B C A B C A B C A B C
0 0 0 0 0 0 0 0 0 0 1 1 1 1 1 1 1 1 1 1 1 1 1
6 6 7 7 7 8 8 8 9 9 9 0 0 0 1 1 1 2 2 2 3 3 3
```
◄REPEAT►

ROW N+2    MESSAGE ◄——— |——➤ CHECK
```
C A B C A B C A B C A B C A B C A B C A B C A
1 1 1 1 1 1 1 1 1 1 1 1 1 1 1 1 1 1 1 1 1 1 2
2 3 3 3 4 4 4 5 5 5 6 6 6 7 7 7 8 8 8 9 9 9 0
```

ROW N+3      |——➤ NEXT BLOCK
```
A B C A B C S S B C A B C A B C A B C A B C A
1 1 1 2 2 2   0 0 0 0 0 0 0 0 0 0 0 0 0 0 0 0
9 9 9 0 0 0 0 1 0 0 1 1 1 2 2 2 3 3 3 4 4 4 5
```
CURRENT BLOCK ◄——— |

ROW N+4
```
A B C A B C A B C A B C A B C A B C A B C A B
0 0 0 0 0 0 0 0 0 0 0 0 0 0 0 0 0 0 0 1 1 1 1
4 4 4 5 5 5 6 6 6 7 7 7 8 8 8 9 9 9 0 0 0 1 1
```

FIG. 6

702 — PIXEL POSITION DURING CURRENT ROW

700 — PIXEL POSITION DURING NEXT ROW

LUMINACE

PARENT

CHILD

PIXELS

GRANDCHILD

TIME

FIG. 7

EP 0 494 267 B1

$P = 0.5$

50%  54%  90%

FIG. 9

| ROW N-2 | 11101000 | 10110100 | 10010110 | 10011100 | 10101010 |
|---|---|---|---|---|---|
| ROW N-1 | 10100101 | 11000011 | 11100001 | 01101001 | 00011110 |
| ROW N | 01101000 | 01001011 | 10100110 | 10100110 | 11100001 |
| TRANSITIONS BETWEEN N-2, N | ↟ | ↟↟↟↟↟↟↟ | ↟↟ | ↟↟↟ ↟ | ↟ ↟ ↟↟ |

FIG. 8

FILM BYTE POSITION (TWO ROWS BUTTED TOGETHER)

0 0 0 0 0 0 0 0 0 1 1 1 1 1 1 1 1 1 1 2 2 2 2 2 2 2 2 2 2 3 3 3 3 3 3 3 3 3
1 2 3 4 5 6 7 8 9 0 1 2 3 4 5 6 7 8 9 0 1 2 3 4 5 6 7 8 9 0 1 2 3 4 5 6 7 8

ROW N
S B C A B C A B C A B C A B C A B C A B C A B C A B C A B C A B C A B C A B
0 0 0 0 0 0 0 0 0 0 0 0 0 0 0 0 0 0 0 0 0 0 0 0 0 0 0 0 0 0 1 1 1 1 1 1 1 1
1 0 0 1 1 1 2 2 2 3 3 3 4 4 4 5 5 5 6 6 6 7 7 7 8 8 8 9 9 9 0 0 0 1 1 1 2 2

ROW N+2
C A B C A B C A B C A B C A B C A B C A B C A B C A B C S S C B A B C A B C A B C
1 1 1 1 1 1 1 1 1 1 1 1 1 1 1 1 1 1 1 1 1 1 2 2 2 0 0 0 0 0 0 0 0 0 0 0
2 3 3 3 4 4 4 5 5 5 6 6 6 7 7 7 8 8 8 9 9 9 0 0 0 0 1 0 0 1 1 1 2 2 2 3 3 3

ROW N+4
A B C A B C A B C A B C A B C A B C A B C A B C A B C A B C A B C A B C A B
0 0 0 0 0 0 0 0 0 0 0 0 0 0 0 0 0 0 0 1 1 1 1 1 1 1 1 1 1 1 1 1 1 1 1 1 1 1
4 4 4 5 5 5 6 6 6 7 7 7 8 8 8 9 9 9 0 0 0 1 1 1 2 2 2 3 3 3 4 4 4 5 5 5 6 6

ROW N+6
C A B C A B C A B C A B C S S C A B C A B C A B C A B C A B C B A B C A B C A B C
1 1 1 1 1 1 1 1 1 1 2 2 2 0 0 0 0 0 0 0 0 0 0 0 0 0 0 0 0 0 0 0 0 0 0 0 0
6 7 7 7 8 8 8 9 9 9 0 0 0 0 1 0 0 1 1 1 2 2 2 3 3 3 4 4 4 5 5 5 6 6 6 7 7 7

FIG. 10

EP 0 494 267 B1

FIG. 11

FIG. 12

EP 0 494 267 B1

CURRENT ROW
ADJUSTED PIXEL VALUES

ROW CLOCK PHASE EVALUATION.

FIG. 13

FIG. 14

FILM

CCD PIXELS

FIG. 15A

FILM BIT

$d_{n-1}$

$d_n$

$\psi_n (FILM)_{(MOD\ 1)} = .5$

$\psi_n (REG.)_{(MOD\ 1)} = .5$

A

FIG. 15B

SIN $2\pi\ \psi_n$ (REG.)

FIG. 15C

COS $2\pi\ \psi_n$ (REG.)

FIG. 15D

$\left| d_n - d_{n-1} \right|$

## DETERMINING ANGLES

ONLY VERY ELEMENTARY TESTS SUFFICE TO DETERMINE A(S,C) TO WITHIN AN ERROR OF $\pm$ 1/16.

**FIG. 16**

IMPROVEMENT OF THE ERROR TO WITHIN $\pm$ 1/32 (APPROXIMATED TO ABOUT 2% OF 1/32 CAN BE DONE AS FOLLOWS:

**FIG. 17**

DEFINE: $\quad s_n = |d_n - d_{n-1}| \sin 2\pi \psi_n$
$\& \quad c_n = |d_n \; d_{n-1}| \cos 2\pi \psi_n$ ⟞ 840

DEFINE: $\quad S_{j,k} = \sum\limits_{n=j}^{k} s_n \quad \& \quad C_{j,k} = \sum\limits_{n=j}^{k} c_n$ ⟞ 842

DEFINE: $\quad A_{j,k} = \dfrac{1}{2\pi} \tan^{-1}\left( \dfrac{S_{j,k}}{C_{j,k}} \right)$ ⟞ 844

DEFINE: $\quad B_{64n + 31\frac{1}{2}} = A_{64n,\; 64n + 63}$
$\& \quad B_{64n - 31\frac{1}{2}} = A_{64n,\; 64n - 63}$ ⟞ 846

DEFINE: $\quad D_{64(n+1)} = B_{64(n+1) + 31\frac{1}{2}} - B_{64(n+1)31\frac{1}{2}}$ ⟞ 848

850

COMPUTE: $\quad D_{AV} = \frac{1}{7}\left( D_0 + D_{64} + D_{64} + D_{2.64} + D_{3.64} + D_{4.64} + D_{5.64} + D_{6.64} \right)$

COMPUTE & STORE RESULTS IN PHASE REGISTER:

$$\Delta\psi \begin{smallmatrix}(REG.)\\ NEW \end{smallmatrix} = \Delta\psi \begin{smallmatrix}(REG.)\\ OLD \end{smallmatrix} - D_{AV}/64$$

$$\& \; \psi_0 \begin{smallmatrix}(REG.)\\ NEW \end{smallmatrix} = \psi_0 \begin{smallmatrix}(REG.)\\ OLD \end{smallmatrix} - \left( A_{0,63} - D_{AV}/2 \right)$$

852

## FIG. 18

FIG. 19

INITIALIZE $\Psi = \Psi_o$ —860

$\Psi_{NEW} = \Psi_{OLD} + 2\Delta\Psi$ —862

864

ARE INTEGER BITS OF $\Psi_{OLD}$ AND $\Psi_{NEW}$ DIFFERENT? — NO

YES

GRAB NEXT ODD PIXEL —866

IS $\Psi$ MOD $I < .375$? —868

870

NO                    YES                    872

GRAB PREVIOUS EVEN PIXEL        GRAB NEXT EVEN PIXEL

874 — WEIGHT ODD & EVEN PIXEL VALUES PER THEIR PROXIMITY TO $\Psi$ MOD $I = .5$

$874a$  $w_{ODD} = \dfrac{|\Psi_{ODD}(MOD\ I) - .5|}{|\Psi_{ODD} - \Psi_{EVEN}|}$

876 — COMPUTE WEIGHTED AVERAGE $d_n'$

$874b$  $w_{EVEN} = \dfrac{|\Psi_{EVEN}(MOD\ I) - .5|}{(\Psi_{ODD} - \Psi_{EVEN})}$

878 — COMPARE $d_n'$ WITH LUMINANCE VALUES $d_I, d_O$ FOR OPAQUE AND CLEAR (0 AND I) BITS AND OUTPUT A ZERO OR ONE BIT AS APPROPRIATE.

$874c$  $d_n' = w_{ODD}\ d_{ODD} + w_{EVEN}\ d_{EVEN}$

880 — OUTPUT AN ERASURE BIT = I IF $d_n'$ IS NOT SUFFICIENTLY CLOSE TO EITHER $d_I$ OR $d_O$

FIG. 20

I CODEWORD
(63 SYMBOLS) —— 930

932

NO. OF
ERASURES
>14 ?

YES ←—— ——→ NO

IGNOR ERASURES
THEN DECODE IT —— 934

942 —— DECODE IT
WITH ERASURES

936

DECODABLE ?

YES ←    →NO

938    940

P-MUTE 1

OUTPUT THE
WHOLE CODEWORD

MUTE THE
WHOLE CODEWORD

944 —— DECODABLE ?

946    YES    NO

GET $\ell'$ AND $S'$

948

$2\ell' + S' \leqq \hbar$ ?

YES    NO

P-MUTE 3    P-MUTE 2

$\ell'$: NO. APPARENT ERRORS
IN A DECODED CODEWORD.

$S'$: NO. OF APPARENT UNREADABLE
ERASURES IN A DECODED
CODEWORD.

$\hbar$ : A PRESET THRESHOLD.

OUTPUT THE
WHOLE CODEWORD

MUTE THE
WHOLE CODEWORD

950    945

FIG. 21

FIG. 22